Europäisches Patentamt

European Patent Office

Office européen des brevets

(11) Numéro de publication: **0 190 796**
**B1**

(12) # FASCICULE DE BREVET EUROPEEN

(45) Date de publication du fascicule du brevet:
20.12.89

(51) Int. Cl.⁴: **H 03 H 17/02**

(21) Numéro de dépôt: **86200130.2**

(22) Date de dépôt: **30.01.86**

(54) Système de bancs de filtres d'analyse et de synthèse d'un signal.

(30) Priorité: **01.02.85 FR 8501429**

(43) Date de publication de la demande:
**13.08.86 Bulletin 86/33**

(45) Mention de la délivrance du brevet:
**20.12.89 Bulletin 89/51**

(84) Etats contractants désignés:
**BE CH DE FR GB IT LI NL SE**

(56) Documents cités:
**IEEE TRANSACTIONS ON ACOUSTICS, SPEECH AND SIGNAL PROCESSING, vol. ASSP-32, no. 3, juin 1984, pages 522-530, IEEE, New York, US; C.R. GALAND et al.: "New quadrature mirror filter structures"
ICASSP 83 PROCEEDINGS, 14-16 avril 1983, Boston, Massachusetts, vol. 1/3, pages 228-231, IEEE, New York, US; V.K. JAIN et al.: "A novel approach to the design of analysis/synthesis filter banks"
ICASSP 84 PROCEEDINGS, 19-21, mars 1984, San Diego, California, vol. 1/3, pages 11.4.1 - 11.4.3., IEEE, New York, US; M. BEACKEN: "Efficient implementation of highly variable bandwidth filter banks with highly decimated output-channels"
ICASSP 85 PROCEEDINGS, 26-29 mars 1985, Tampa, Florida, vol. 2/4, pages 14.7.1 - 14.7.4, IEEE, New York, US; J. MASSON et al. "Flexible design of computationaly efficient nearly perfect QMF filter banks"**

(73) Titulaire: **TELECOMMUNICATIONS RADIOELECTRIQUES ET TELEPHONIQUES T.R.T., 88, rue Brillat Savarin, F-75013 Paris (FR)**

(72) Inventeur: **Masson, Jacques Lucien Raymond, SOCIETE CIVILE S.P.I.D. 209 rue de l'Université, F-75007 Paris (FR)**
Inventeur: **Picel, Zdenek, SOCIETE CIVILE S.P.I.D. 209 rue de l'Université, F-75007 Paris (FR)**

(74) Mandataire: **Chaffraix, Jean et al, Société Civile S.P.I.D. 209, rue de l'Université, F-75007 Paris (FR)**

## Description

L'invention concerne un système de traitement numérique de signal comprenant un banc de filtres d'analyse pour décomposer un signal entrant échantilloné à la fréquence $f_e$ et occupant une bande de fréquences limitée à $f_e/2$, en N signaux de sous-bandes contiguës de largeur $f_e/2N$, échantillonnées à la fréquence $f_e/N$, un banc de filtres de synthèse pour reconstituer ledit signal entrant à partir desdits signaux de sous-bandes, lesdits bancs de filtres étant formés par modulation d'un filtre prototype passe-bas ayant une réponse impulsionnelle finie et symétrique, une fréquence $f_a$ de début de bande atténuée inférieure à $f_e/2N$ et répondant à la condition $H^2(f) + H^2(f_e/2N - f) = 1$ dans la bande de fréquence f allant de 0 à $f_a$, H(f) étant le module de la réponse en fréquence, la modulation du filtre prototype étant réalisée par N signaux de modulation sinusoïdaux caractérisés, pour former la Kième sous-bande (k allant de 0 à N − 1), par la fréquence

$$f_k = \frac{f_e}{4N} (2k + 1),$$

par la phase $\alpha_k$ pour le banc d'analyse et la phase − $\alpha_k$ pour le banc de synthèse, la phase $\alpha_k$ étant telle que pour la sous-bande d'ordre

$$k = 0, \ \alpha_0 = \frac{\Pi}{4}, \ \frac{3\Pi}{4}, \ \frac{5\Pi}{4} \ \text{ou} \ \frac{7\Pi}{4}$$

et telle que pour deux sous-bandes contiguës d'ordre

$$k \ \text{et} \ k - 1, \ \alpha_k - \alpha_{k-1} = \frac{\Pi}{2} \ \text{ou} \ - \frac{\Pi}{2}.$$

De tels systèmes comprenant en cascade un banc d'analyse et un banc de synthèse peuvent être utilisés par exemple pour coder un signal de parole avec un débit réduit, en quantifiant les signaux de sous-bandes fournis par le banc d'analyse, avec un nombre de niveau variable, dépendant de l'énergie de chaque signal de sous-bande.

Dans les bancs de filtres envisagés, pour réduire la complexité des filtres, ceux-ci ont des bandes de transition relativement larges, qui se recouvrent partiellement pour des filtres contigus, de sorte que le signal reconstitué sortant du banc de synthèse peut être affecté de termes parasites dûs à des repliements spectraux inévitables et présentant un niveau gênant.

On peut éviter l'influence de ces repliements spectraux en choisissant convenablement les couples correspondants de filtres des bancs d'analyse et de synthèse.

Cette possibilité a été démontrée pour des bancs de filtres à deux sous-bandes et étendue à des bancs de filtres à nombre de sous-bandes égal à une puissance de deux, grâce à l'utilisation de filtres demi-bandes particuliers: voir à ce sujet l'article de A. Croisier, D. Esteban, C. Galand, intitulé «Perfect Channel Splitting by Use of Interpolation/Decimation, Tree Decomposition Techniques» et paru dans Proc. of International Conference on Inf. Sciences/Systems, pages 443–446, Patras, Août 1976. Mais outre que ce procédé est limité en ce qui concerne le nombre de sous-bandes possible, il conduit à un volume de calculs et de mémoires relativement important.

Pour réaliser de façon efficace des bancs de filtres, on connaît la technique initialement développée dans les systèmes transmultiplexeurs et consistant à utiliser pour un banc de filtres une structure constituée par un réseau polyphasé associé à une transformée de Fourier rapide: voir à ce sujet l'article de M.G. Bellanger et J.L. Daguet, intitulé «TDM–FDM Transmultiplexer: Digital Polyphase and FFT», et paru dans IEEE Trans. COM, vol COM–22, N° 9, sept. 1974. On doit noter toutefois que dans cette application les sous-bandes à réaliser sont disjointes et le problème des repliements est évité par des filtres à bande de transition étroite et située entre les sous-bandes.

Une technique du genre utilisé dans les systèmes transmultiplexeurs, mais convenant pour réaliser les bancs de filtres d'analyse et de synthèse du système présentement envisagé, c'est-à-dire procurant des sous-bandes non disjointes, a été étudié pour certains cas particuliers par J.H. Rothweiler dans l'article intitulé «Polyphase Quadrature Filters – A New Subband Coding Technique» et paru dans Proc. of ICASSP 83, Boston, pages 1280–1283, et par H.J. Nussbaumer et M. Vetterli dans l'article intitulé «Computationaly Efficient QMF Filter Banks» et paru dans Proc. of ICASSP 84, San Diego, pages 1131–1134. Pour ces cas particuliers, généralement le nombre de sous-bandes est une puissance de deux, et le nombre de coefficients de chaque filtre du banc de filtres est un multiple du nombre de sous-bandes, ce qui signifie dans une réalisation par réseau polyphasé et transformée de Fourier, un même nombre pair de coefficients dans toutes les branches du réseau polyphasé.

La présente invention vise à éviter toutes ces limitations et à fournir un couple de bancs de filtres d'analyse et de synthèse nécessitant le minimum de calculs et de mémoires, même quand le nombre de sous-bandes requis n'est pas une puissance de deux et que le nombre de coefficients requis pour chaque filtre est différent d'un multiple du nombre de sous-bandes (c'est-à-dire que les branches du réseau polyphasé ont un nombre de coefficients variable).

Conformément à l'invention, dans un système de traitement numérique de signal échantillonné à la fréquence $f_e$, comprenant un banc de filtres d'analyse et un banc de filtres de synthèse formés par modulation d'un filtre prototype par des signaux de modulation sinusoïdaux de fréquence

$$f_k = \frac{f_e}{4N} (2k + 1)$$

et de phase $\pm \alpha_k$ respectivement pour le banc d'analyse et le banc de synthèse, la phase $\alpha_k$

étant telle que pour la sous-bande d'ordre

$$k = 0, \; \alpha_0 = \frac{\Pi}{4}, \; \frac{3\Pi}{4}, \; \frac{5\Pi}{4} \text{ ou } \frac{7\Pi}{4}$$

et telle que pour deux sous-bandes contiguës d'ordres

$$k \text{ et } k - 1,$$

lesdits signaux de modulation sont en outre retardés du temps

$$\tau = \frac{N_c - 1}{2} \; \frac{1}{f_e}, \quad \alpha_k - \alpha_{k-1} = \pm \frac{\Pi}{2},$$

$N_c$ étant le nombre de coefficients requis pour réaliser les caractéristiques du filtre prototype.

Dans une implantation efficace du système de l'invention, le banc d'analyse est formé par:
– un réseau polyphasé à N branches sur lesquelles sont répartis à chaque période NT, N échantillons du signal entrant dans le banc d'analyse, ce réseau polyphasé étant agencée pour calculer à chaque période NT, caractérisée par m et pour chacune de ses branches caractérisée par p (variant de 0 à N – 1), un signal $P_p(m)$ formé à partir de $\lambda$ coefficients consécutifs entrés dans la branche, $\lambda$ étant la valeur entière de

$$\frac{N + N_c - 1}{N},$$

– un dispositif de calcul de transformée en cosinus discrète doublement impaire recevant les N signaux $P_p(m)$ fournis par le réseau polyphasé et agencé pour calculer les N signaux de sous-bande X(m) suivant l'expression:

$$X_k(m) = \sum_{\rho = 0}^{N - 1} C_N(k, \; \rho) . P_\rho(m)$$

où les cœfficients $C_N(k, \rho)$ sont tels que

$$C_N(k, \; \rho) = 2 \cos \left[ \frac{(2k + 1)(2\rho + 1)\Pi}{4N} \right]$$

Il est également avantageux de former le banc de synthèse de façon analogue à l'aide d'un dispositif de calcul de transformée en cosinus discrète doublement impaire, recevant les signaux de sous-bande et couplé à un réseau polyphasé dont les signaux de sortie sont répartis dans le temps pour former le signal de sortie du banc de synthèse.

La description suivante en regard des dessins annexés, le tout donné à titre d'exemple, fera bien comprendre comment l'invention peut être réalisée.

La fig. 1 représente un schéma synoptique du système de l'invention, dans une structure parallèle.

La fig. 2 représente en 2a, 2b, 2c, le module des réponses en fréquence des filtres d'analyse et de synthèse d'ordres 0, 1 ... N – 1.

La fig. 3 représente en 3a le module de la réponse en fréquence du filtre prototype et en 3b, 3c, 3d le spectre des signaux de modulation du filtre prototype, permettant d'obtenir les filtres d'analyse et de synthèse d'ordres 0, 1, ... N – 1.

La fig. 4 représente un schéma synoptique du système de l'invention, dans une structure comprenant un réseau polyphasé et un dispositif de calcul de transformée en cosinus discrète pour réaliser chaque banc de filtres.

La fig. 5 représente un mode de réalisation d'une première partie du réseau polyphasé d'analyse.

La fig. 6 représente un mode de réalisation de la partie terminale du réseau polyphasé d'analyse et du dispositif associé de calcul de transformée en cosinus discrète.

La fig. 7 représente un mode de réalisation du dispositif de calcul de transformée en cosinus discrète, utilisé pour réaliser le banc de synthèse.

La fig. 8 représente un mode de réalisation du réseau polyphasé de synthèse.

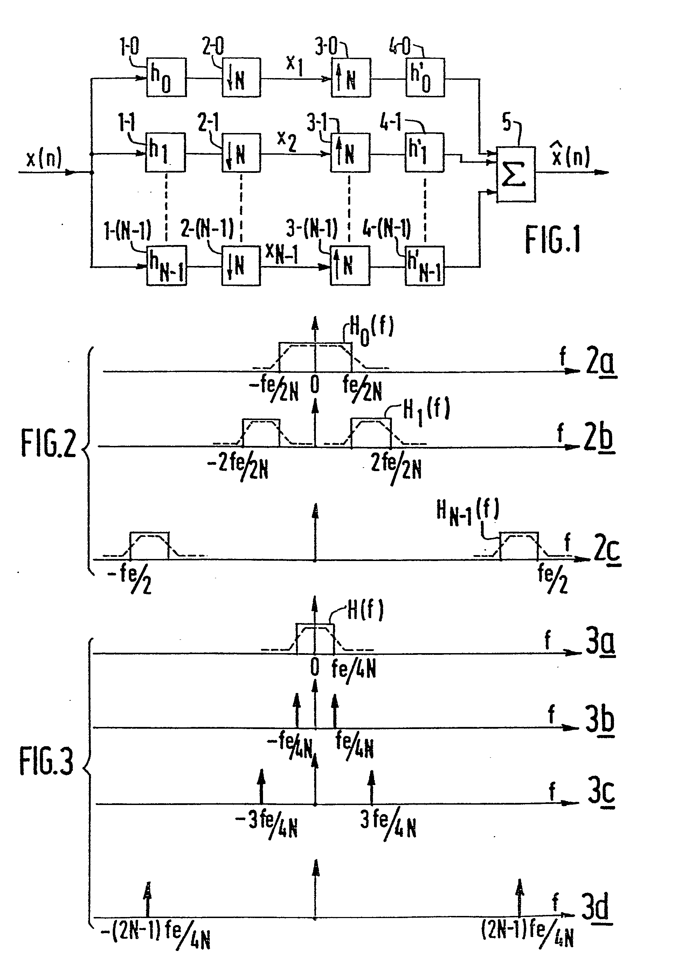

La figure 1 représente sous sa forme parallèle le système de traitement de l'invention destiné à décomposer un signal entrant en signaux de sous-bandes contiguës et à reconstituer le signal entrant à partir des signaux de sous-bandes, en vue, par exemple, de réduire le débit binaire du signal par un codage convenable des signaux de sous-bandes.

Le signal entrant x(n) échantillonné à la fréquence d'échantillonnage $f_e$, à des instants nT ($T = 1/f_e$) et occupant une bande de fréquence limitée à la fréquence $f_e/2$, est appliqué à un banc de filtres d'analyse constitué par les filtres en parallèle 1 – 0 à 1 – (N – 1) ayant les réponses impulsionnelles $h_0$ à $h_{N-1}$ pour diviser la bande de fréquences (0, $f_e/2$) du signal entrant en N sous-bandes contiguës de largeur $f_e/2N$. Les dispositifs de sous-échantillonnage 2 – 0 à 2 – (N – 1) prélèvent un échantillon sur N dans les signaux sortant des filtres du banc d'analyse et fournissent ainsi les signaux de sous-bandes $x_0$ à $x_{N-1}$ échantillonnés à la fréquence $f_e/N$. Le sous-échantillonnage ainsi opéré a pour effet d'amener tous les signaux sortant des filtres dans la bande de base 0 – $f_e/2N$. Pour la commodité, on n'a pas représenté le traitement tel qu'une quantification adaptative, effectué sur les signaux $x_0$ à $x_{N-1}$ et ceux-ci sont donc appliqués selon la figure à des dispositifs 3 – 0 à 3 – (N – 1) amenant la fréquence d'échantillonnage à la valeur $f_e$, par adjonction de (N – 1) zéros entre deux échantillons consécutifs de ces signaux. Le suréchantillonnage ainsi opéré a pour effet de répartir avec une périodicité fréquentielle $f_e/2$, le spectre des signaux de sous-bande $x_0$ à $x_{N-1}$. Les signaux sortant des dispositifs de suréchantillonnage 3 – 0 à

3 − (N − 1) sont appliqués au banc de filtres de synthèse constitué par les filtres 4 − 0 à 4 − (N − 1) ayant les réponses impulsionnelles h′$_0$ à h′$_{N-1}$ de façon à fournir les mêmes signaux que ceux fournis par les filtres 1 − 0 à 1 − (N − 1) du banc d'analyse. Enfin les signaux sortant des filtres 4 − 0 à 4 − (N − 1) sont appliqués au dispositif de sommation 5 qui fournit le signal de sortie x̂(n) qui doit être une réplique aussi exacte que possible du signal entrant x(n).

Les diagrammes de la figure 2 représentent, en traits pleins, les modules des réponses en fréquences des filtres des bancs d'analyse et de synthèse, dans le cas idéal où ces filtres ont une raideur de coupure et une atténuation infinies. Les diagrammes 2a, 2b, 2c montrent respectivement les réponses H$_0$(f), H$_1$(f), H$_{N-1}$(f) des filtres 1 − 0, 1 − 1, 1 − (N − 1) du banc d'analyse et des filtres 4 − 0, 4 − 1, 4 − (N − 1) du banc de synthèse. Avec des filtres ayant ces caractéristiques idéales, le signal x̂(n) sortant du banc de synthèse constitue une réplique parfaite du signal entrant x(n). Dans le cas de filtres physiquement réalisables, ayant des réponses en fréquence du genre représenté en pointillé sur les diagrammes, les réponses en fréquence des différents filtres de chaque banc se recouvrent partiellement et le signal sortant x̂(n) comporte des termes parasites dûs à des repliements spectraux.

Suivant une technique connue, utilisée par exemple dans les documents précités de Rothweiler et Nussbaumer, les filtres des bancs d'analyse et de synthèse sont obtenus par modulation d'un filtre prototype qui, dans un cas parfait, a la caractéristique d'un filtre passe-bas idéal, à fréquence de coupure f$_e$/4, le diagramme 3a de la figure 3 représentant le module de la réponse en fréquence H(f) d'un tel filtre. Les signaux de modulation du filtre prototype sont sinusoïdaux et ont des fréquences multiples impaires de f$_e$/4N, soient (2k + 1) f$_e$/4N avec K allant de 0 à N − 1. Les diagrammes 3b, 3c, 3d montrent les spectres de ces signaux de modulation, respectivement pour les fréquences de modulation telles que k = 0, k = 1 et k = N − 1, permettant d'obtenir les réponses H$_0$ (f), H$_1$ (f), H$_{N-1}$ (f) représentées sur la figure 2.

Le filtre passe-bas prototype est réalisé comme un filtre à réponse impulsionnelle finie et ne peut évidemment avoir une raideur de coupure infinie, comme le représente la réponse en traits pleins du diagramme 3a. Un filtre prototype physiquement réalisable doit répondre à plusieurs exigences démontrées par la suite pour que le système complet analyse-synthèse remplisse sa fonction. Si l'on appelle f$_a$ la fréquence de début de la bande atténuée du filtre prototype, on peut montrer que les termes de repliement parasites apparaissant dans le signal sortant x̂(n) peuvent être éliminés si f$_a$ < f$_e$/2N. Le diagramme 3a représente en pointillé l'allure de la réponse en fréquence d'un filtre prototype répondant à cette exigence. D'autre part, pour que le système analyse-synthèse ait une réponse en fréquence unitaire et une phase linéaire (système équivalent à un simple retard), le filtre prototype doit être choisi symétrique et doit satisfaire à la condition de quadrature:

$$H^2 (f) + H^2 (f_e/2N - f) = 1 \qquad (1)$$
$$\text{avec } 0 < f < f_a$$

D'autre part, les signaux de modulation du filtre prototype de fréquences (2k + 1) f$_e$/4N, doivent répondre aux exigences de phase suivantes que l'on peut déduire de l'article de Rothweiler précité: le signal de modulation produisant la ième sous-bande, doit avoir la phase α$_k$ pour le banc d'analyse et le phase α$_k$ pour le banc de synthèse, la phase α$_k$ étant telle que pour la sous-bande d'ordre

$$k = 0, \quad \alpha_0 = \frac{\Pi}{4}, \frac{3\Pi}{4}, \qquad \frac{5\Pi}{4} \text{ ou } \frac{7\Pi}{4}$$

et telle que pour deux sous-bandes contiguës d'ordres

$$k \text{ et } k - 1, \quad \alpha_k - \alpha_{k-1} = \pm \frac{\Pi}{2}.$$

A titre d'exemple, on se placera par la suite dans le cas où

$$\alpha_0 = \frac{\Pi}{4} \text{ et } \alpha_k - \alpha_{k-1} = \frac{\Pi}{2},$$

de sorte que

$$\alpha_k = (2k + 1)\frac{\Pi}{4}.$$

Mais dans les systèmes connus de Nussbaumer et Rothweiler, le nombre de coefficients N$_c$ du filtre prototype est nécessairement relié au nombre 11 de sous-bandes par une relation du type N$_c$ = 2aN ou N$_c$ = 2aN + 1, a étant un nombre entier. Ceci constitue une sérieuse limitation de ces systèmes, notamment lorsque le nombre N de sous-bandes est élevé, puisque pour satisfaire à l'une de ces relations, on est généralement conduit à utiliser pour le filtre prototype un nombre de coefficients N$_c$ plus élevé que celui strictement nécessaire pour obtenir les caractéristiques de filtrage requises. D'autre part, ces systèmes connus ne sont pratiquement décrits que dans le cas où le nombre N de sous-bandes est une puissance 2, alors que par exemple, un nombre de sous-bandes tel que 12 paraît bien adapté pour découper la bande de 4 kHz d'un signal téléphonique. Au total, les systèmes d'analyse et de synthèse connus manquent de souplesse et ne permettent pas le plus souvent la réduction optimale du volume de calculs et de mémoires.

La présente invention permet d'éviter ces inconvénients en traitant de façon optimale le cas d'un nombre de sous-bandes différent d'une puissance de deux avec un nombre de coefficients du filtre prototype indépendant du nombre de sous-bandes.

Conformément à l'invention, les signaux de modulation sont en outre retardés du temps

$$\tau = \frac{N_c - 1}{2} \cdot \frac{1}{f_e}.$$

$$h_k(n) = 2 \cos \left[ 2\Pi \frac{2k + 1}{4N} (n - \frac{N_c - 1}{2}) + (2k + 1) \frac{\Pi}{4} \right] . h(n) \qquad (2)$$

$$h'_k(n) = 2 \cos \left[ 2\Pi \frac{2k + 1}{4N} (n - \frac{N_c - 1}{2}) - (2k + 1) \frac{\Pi}{4} \right] . h(n) \qquad (3)$$

Dans ces expressions (2) et (3), on a pris à titre d'exemple le cas cité plus haut où

$$\alpha_k = (2 k + 1) \frac{\Pi}{4}$$

D'autre part, ces expressions sont valables, les N valeurs de k allant de 0 à N − 1 et $N_c$ valeurs de n allant de 0 à $N_c$ − 1.

Ces formules font notamment apparaître que les coefficients $h_k(n)$ et $h'_k(n)$ des filtres d'analyse et de synthèse dépendent du nombre $N_c$ de coefficients du filtre prototype, ce nombre $N_c$ pouvant être quelconque et déterminé notamment pour satisfaire à des exigences de raideur de coupure. Dans les systèmes connus, ce nombre $N_c$ est relié à N par des relations précisées ci-dessus et n'apparaît pas dans les formules correspondantes connues (voir par exemple l'article précité de Nussbaumer, formule (1)). On peut dire d'une autre manière que dans les systèmes connus, les filtres déterminés par les coefficients $h_k(n)$ et $h'_k(n)$ doivent être chacun symétriques (à phase linéaire), alors que cette exigence n'existe pas dans le système de l'invention, pourvu que chaque couple des filtres $h_k(n)$ et $h'_k(n)$ en cascade se comporte comme un filtre à phase linéaire.

On va maintenant démontrer que le système de l'invention de la figure 1, muni des filtres d'analyse et de synthèse ayant les coefficients $h_k(n)$ et $h'_k(n)$ définis par les formules (2) et (3), remplit sa fonction en éliminant pratiquement les termes de repliement et en se comportant pratiquement comme un retard pur.

Pour cela, on va d'abord écrire les équations reliant les signaux d'entrée et de sortie du système x(n) et x̂(n), en fonction des filtres ayant les coefficients $h_k(n)$ et $h'_k(n)$.

Les calculs s'effectuent dans le plan des Z où:

$$Z = e^{-2\Pi j f T} \quad avec$$

$$j^2 = -1, \quad T = \frac{1}{f_e}$$

Ainsi, en prenant en compte toutes les exigences requises pour les signaux de modulation (fréquence, phase et retard) et en tenant compte du fait que ces signaux sont échantillonnés à la fréquence $f_e$ (instants d'échantillonnage $n/f_e$), il est aisé de voir que le nième cœfficient $h_k(n)$ du kième filtre du banc d'analyse et le nième coefficient $h'_k(n)$ du kième filtre du banc de synthèse peuvent se déduire du nième coefficient h (n) du filtre prototype, selon les expressions:

on note:

$$W = e^{-2\Pi j /N}$$

Suivant l'usage, les variables transformées dans le plan des Z sont écrites avec des majuscules.

Le signal $x_k$ de la kième sous-bande fourni par le banc d'analyse est obtenu par filtrage du signal d'entrée par le filtre de coefficients $h_k(n)$ suivi d'un sous-échantillonnage d'un facteur 1/N par un dispositif 2 − k. Ce sous-échantillonnage ramène le signal utile de la kième sous-bande dans la bande de base (− $f_e$/2N, + $f_e$/2N), mais également toutes les composantes du signal imparfaitement filtrées qui représentent les termes de repliement spectraux. Dans le plan des Z, ce signal $x_k$ peut s'écrire:

$$X_k(Z^N) = \sum_{u = 0}^{N - 1} H_k(W^u Z) . X(W^u Z)$$

La valeur u = 0 de la variable u fournit la contribution du signal utile dans le signal de la sous-bande k ramené en bande de base et les valeurs u=1 à N−1 fournissent les contributions des composantes parasites repliées dans la bande de base et provenant des autres sous-bandes.

Après suréchantillonnage d'un facteur N par ajout de zéros dans un dispositif 3 − k, le signal transformé de la sous-bande devient:

$$\tilde{X}_k(Z) = \sum_{u = 0}^{N - 1} H_k(W^u Z) . X(W^u Z)$$

Le signal de la sous-bande k, filtré par le filtre de synthèse de coefficients $h'_k(n)$ s'écrit alors dans le plan transformé:

$$\hat{X}_k(Z) = H'_k(Z) \sum_{u = 0}^{N - 1} H_k(W^u Z) . X(W^u Z)$$

La transformée en Z du signal $\hat{x}(n)$ sortant du banc de synthèse peut donc s'écrire:

$$\hat{X}(Z) = \sum_{k=0}^{N-1} H'_k(Z) \sum_{u=0}^{N-1} H_k(W^u Z) \cdot X(W^u Z)$$

En posant:

$$G_u(Z) = \sum_{k=0}^{N-1} H'_k(Z) \cdot H_k(W^u Z), \qquad (4)$$

on peut écrire:

$$\hat{X}(Z) = \sum_{u=0}^{N-1} G_u(Z) \cdot X(W^u Z) \qquad (5)$$

Pour que le système complet analyse-synthèse soit équivalent à un retard pur DT, il faut que $\hat{X}(Z) = Z^{-D} \cdot X(Z)$, c'est-à-dire d'après (5):

$$(6) \qquad \begin{cases} G_0(Z) = Z^{-D} \\ G_u(Z) = 0 \quad \text{pour u allant de 1 à N − 1} \end{cases}$$

Des relations (2) et (3) donnant les expressions des coefficients $h_k(n)$ et $h'_k(n)$, on peut déduire aisément que leurs transformées en Z peuvent s'écrire respectivement:

$$H_k(Z) = e^{j\varphi_k} \cdot H\left(W^{\frac{2k+1}{4}} Z\right) + e^{-j\varphi_k} \cdot H\left(W^{-\frac{2k+1}{4}} Z\right) \qquad (7)$$

$$H'_k(Z) = e^{j\psi_k} \cdot H\left(W^{\frac{2k+1}{4}} Z\right) + e^{-j\psi_k} \cdot H\left(W^{-\frac{2k+1}{4}} Z\right) \qquad (8)$$

$$\text{avec} \qquad \begin{cases} \varphi_k = (N - N_c + 1) \dfrac{(2k+1)\Pi}{4N} \\ \psi_k = (-N - N_c + 1) \dfrac{(2k+1)\Pi}{4N} \end{cases} \qquad (9)$$

Ces expressions de $H_k(Z)$ et $H'_k(Z)$ peuvent être reportées dans l'expression (4) de $G_u(Z)$.

On examine d'abord le cas de u = 0. En remplaçant dans l'expression (4) W et Z par leurs valeurs, on peut montrer que:

$$G_0(f) = e^{-2\Pi j f (N_c - 1) T} \cdot \left( \sum_{k=0}^{N-1} \left[ H^2\left(f - \frac{2k+1}{4N} f_e\right) + H^2\left(f + \frac{2k+1}{4N} f_e\right) \right] \right)$$

où H(f) est le module de la réponse en fréquence du filtre prototype. On vérifie aisément que la condition de quadrature du filtre prototype donnée en (1), permet de satisfaire la relation:

$$H^2\left(f - \frac{2k+1}{4N} f_e\right) + H^2\left(f + \frac{2k+1}{4N} f_e\right) = 1 \quad \text{quel que soit k.}$$

On en déduit que $G_0(f) = e^{-2\Pi j f(N_c - 1)T}$ ce qui signifie que la valeur utile du signal de sortie $\hat{X}(Z)$ est le signal entrant X(Z), retardé du temps DT = $(N_c - 1) T$, égal au double du retard procuré par le filtre prototype à $N_c$ coefficients.

On examine maintenant le cas où u = 1 à N − 1, pour lequel on veut montrer que $G_u(Z) = 0$, ce qui signifie que dans le signal de sortie $\hat{X}(Z)$, les composantes parasites dues aux repliements spectraux sont éliminées.

En tenant compte des relations (7) et (8), l'expression (4) de $G_u(Z)$ peut se mettre sous la forme:

$$G_u(Z) = \sum_{k=0}^{N-1} \left[ e^{j(\varphi_k + \psi_k)} . H(W^{\frac{4u+2k+1}{4}} Z) . H(W^{\frac{2k+1}{4}} Z) \right.$$
$$+ e^{j(\varphi_k - \psi_k)} . H(W^{\frac{4u+2k+1}{4}} Z) . H(W^{-\frac{2k+1}{4}} Z)$$
$$+ e^{-j(\varphi_k - \psi_k)} . H(W^{\frac{4u-2k-1}{4}} Z) . H(W^{\frac{2k+1}{4}} Z)$$
$$\left. + e^{-j(\varphi_k + \psi_k)} . H(W^{\frac{4u-2k-1}{4}} Z) . H(W^{-\frac{2k+1}{4}} Z) \right]$$

On voit apparaître des termes du type $H(W^{p/4}Z) \cdot H(W^{q/4}Z)$ correspondant au produit de deux filtres issus du filtre prototype par translation l'un de

$$\frac{p}{2} \cdot \frac{f_e}{N}$$

et l'autre de

$$\frac{q}{4} \cdot \frac{f_e}{N} \; .$$

En supposant l'atténuation du filtre prototype suffisamment forte (au moins 40 dB), on peut négliger les termes pour lesquels p et q sont tels qu'il n'y a pas de zones de recouvrement entre les $H(W^{p/4}Z)$ et $H(W^{q/4}Z)$, bandes passante et de transition comprises. Il ne subsiste plus que les termes du type $H(W^{p/4}Z)$ pour lesquels p et q sont tels qu'il y a recouvrement, c'est-à-dire tels que k = u et k = u − 1 (ce qui correspond à deux sous-bandes contiguës). On peut montrer alors que, la dernière expression de $G_u(Z)$ peut se simplifier comme suit:

$$G_u(Z) = H(-W^{\frac{2u+1}{4}} Z) . H(-W^{\frac{2u-1}{4}} Z) . \left[ e^{j(\varphi_{N-u} - \psi_{N-u})} \right.$$
$$\left. + e^{j(\varphi_{N-u-1} - \psi_{N-u-1})} \right] + H(W^{\frac{2u+1}{4}} Z) . H(W^{\frac{2u-1}{4}} Z)$$
$$. \left[ e^{-j(\varphi_u - \psi_u)} + e^{-j(\varphi_{u-1} - \psi_{u-1})} \right]$$

En remplaçant les termes $\varphi_u$, $\psi_u$, $\varphi_{N-u}$, $\psi_{N-u}$, etc... par leurs valeurs données en (9) pour u = k, on trouve: $G_u(Z) = 0$ pour $1 \leq u \leq N-1$ ce qui est la relation à vérifier pour que les termes de repliement soient annulés dans le signal sortant du banc de synthèse.

Pratiquement, on a pu réaliser un système analyse-synthèse divisant la bande de 4 kHz du signal de parole échantillonné à 8 kHz en 12 sous-bandes de largeur $f_e/2N = 333$ Hz, avec un filtre prototype ayant un nombre de coefficients $N_c = 66$ pour obtenir à la fréquence

$$\frac{f_e}{4N} = 166 \; Hz$$

une atténuation de 3 dB et au-delà de la fréquence

$$\frac{f_e}{2N} = 333 \; Hz$$

une atténuation croissante supérieure à 40 dB, la condition de quadrature (1) étant satisfaite dans la bande 0–333 Hz.

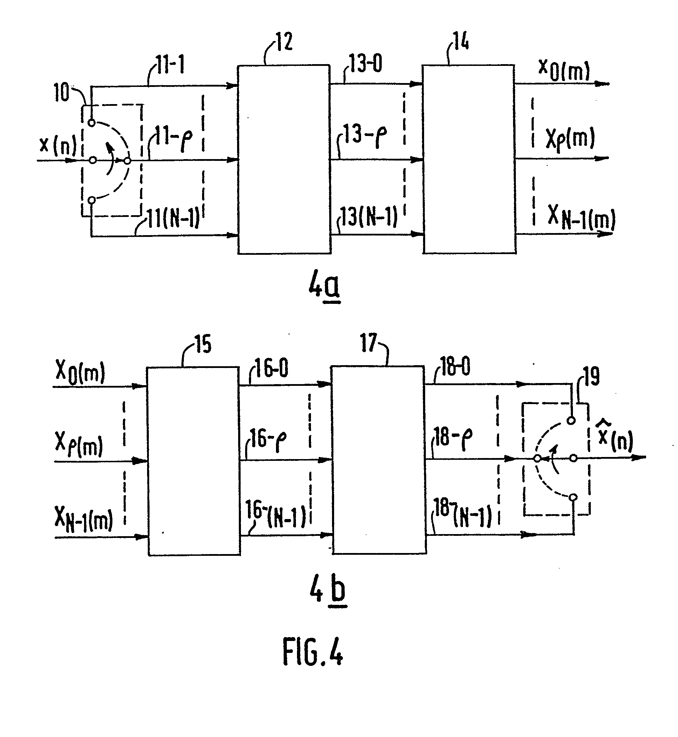

On va maintenant montrer comment les bancs de filtres d'analyse et de synthèse du système de l'invention peuvent être implantés de façon particulièrement efficace suivant les schémas synoptiques de la figure 4. Suivant le schéma 4a représentant le banc d'analyse, le signal entrant x(n) échantillonné à la fréquence $f_e$ est appliqué à un circuit commutateur 10 qui répartit cycliquement sur N branches 11−ρ (ρ allant de 0 à N−1) les échantillons de x(n) de sorte que la fréquence d'échantillonnage dans chaque branche est réduite à $f_e/N$. Les N signaux dans les branches 11−ρ sont appliqués à un réseau polyphasé d'analyse 12 à l'entrée duquel on suppose que leurs échantillons sont remis en phase et dans lequel ils font l'objet d'un traitement qui sera expliqué par la suite. Les N signaux sortant des branches 13−ρ du réseau polyphasé 12 sont appliqués à un dispositif de traitement 14 calculant une transformée en cosinus discrète doublement impaire, comme on le précisera par la suite. Les N signaux sortant du dispositif de traitement 14 constituent les signaux sous-échantillonnés (fréquence d'échantillonnage $f_e/N$) sortant du banc d'analyse et notés $x_0$ à $x_{N-1}$ sur la figure 1. Sur la figure 4a, ces signaux sont notés pour la commodité $X_k(m)$, k allant de 0 à $N^1$ caractérisant la sous-bande d'un signal et m l'instant d'échantillonnage.

D'après la figure 4b représentant le banc de synthèse, les N signaux $X_k(m)$ sortant du banc d'analyse sont appliqués à un dispositif de traitement 15 calculant une transformée en cosinus discrète doublement impaire, précisée par la suite. Les N signaux sortant du dispositif de traitement 15 sont appliqués aux branches d'entrée $16 - \rho$ d'un réseau polyphasé de synthèse 17 dans lequel ils font l'objet d'un traitement qui sera précisé par la suite. Les N signaux apparaissant sur les branches de sortie $18 - \rho$ du réseau polyphasé 17 sont échantillonnés à la fréquence réduite

$f_e/N$, avec des échantillons que l'on peut supposer en phase dans les N branches. Ces N signaux sont appliqués respectivement sur les N entrées du circuit commutateur 19 qui répartit dans le temps leurs échantillons, de façon à former à sa sortie un signal échantillonné à la fréquence $f_e$ qui constitue le signal $\hat{x}(n)$ sortant du banc de synthèse.

On va maintenant expliquer comment ces structures 4a et 4b permettent de réaliser les opérations à effectuer respectivement dans le banc d'analyse et dans le banc de synthèse.

L'explication est donnée d'abord pour le banc d'analyse. A chaque instant mNT le signal $X_k(m)$ de la sous-bande k formée par le banc d'analyse résulte d'une convolution entre les $N_c$ coefficients $h_k(n)$ du filtre déterminant cette sous-bande et $N_c$ échantillons consécutifs du signal entrés dans le banc d'analyse jusqu'à l'instant mNT. Ce signal $X_k(m)$ peut donc s'écrire:

$$X_k(m) = \sum_{n=0}^{N_c - 1} h_k(n) . \dot{x}(mN - n) \qquad (10)$$

On pose:

$$\lambda = E\left[\frac{N + N_c - 1}{N}\right] \qquad (10a)$$

où E(x) représente la valeur entière de x.

Dans l'expression (10), on peut effectuer un changement de variables permettant de déterminer la variable n par deux autres variables r et $\rho$ telles que:

$n = rN + \rho$ avec $\rho$ variant de 0 à $N - 1$ et r variant de 0 à $\lambda - 1$

On peut noter qu'avec l'excursion complète des variables r et $\varrho$ la variable n varie de 0 à $\lambda N - 1$. Si, comme le permet la présente invention, le nombre $N_c$ des coefficients $h_k(n)$ est inférieur à $\lambda N$, les valeurs de $h_k(n)$ pour n allant de $N_c$ à $\lambda N - 1$ doivent être choisies nulles, ces valeurs nulles étant réparties de façon symétrique aux extrémités de la réponse impulsionnelle $h_k(n)$ ce qui impose que $\lambda N - N_c$ soit pair.

Avec ce changement de variables et en utilisant pour les coefficients $h_k(n)$ les valeurs données par l'expression (2), l'expression (10) de $X_k(m)$ devient:

$$X_k(m) = \sum_{\rho=0}^{N-1} \sum_{r=0}^{\lambda-1} \cos\left[\frac{(2k+1)(2\rho+1+N)\Pi}{4N} + (2k+1)(2r-\lambda)\frac{\Pi}{4}\right] h(rN+\rho) . x\left[(m-2)N - \rho\right] \qquad (11)$$

On peut écrire de façon différente cette formule (11), en utilisant les notations suivantes:

$$\hat{h}_\rho(r) \quad = h(rN + \rho)$$

$$x_\rho(r) \quad = x(rN - \rho)$$

$$C_N(k,\rho) \quad = 2 \cos\left[\frac{(2k + 1)(2\rho + 1)}{4N}\Pi\right]$$

$$S_N(k,\rho) \quad = 2 \sin\left[\frac{(2k + 1)(2\rho + 1)}{4N}\Pi\right] \qquad (12)$$

Avec ces notations on peut montrer que l'expression (11) peut se mettre sous la forme suivante avec $\lambda$ et N pairs:

$$X_k(m) = \sum_{\rho = 0}^{N - 1} \sum_{r = 0}^{\lambda - 1} \left[ C_N(k,\rho + \frac{N}{2})\cos((2r - \lambda)\frac{\Pi}{4}) \right.$$

$$\cdot \hat{h}_\rho(r).x_\rho(m - r) - C_N(k,\rho - \frac{N}{2})\sin(2r - \lambda)\frac{\Pi}{4}) \qquad (13)$$

$$\left. \cdot \hat{h}_\rho(r).x_\rho(m - r)\right]$$

En posant:

$$P_\rho^{(1)}(m) = \sum_{r = 0}^{\lambda - 1} \hat{h}_\rho(r) \cos((2r - \lambda)\frac{\Pi}{4}).x_\rho(m - r.)$$

$$\qquad (14)$$

$$P_\rho^{(2)}(m) = -\sum_{r = 0}^{\lambda - 1} \hat{h}_\rho(r) \sin((2r - \lambda)\frac{\Pi}{4}).x_\rho(m - r)$$

l'expression (13) devient:

$$X_k(m) = \sum_{\rho = 0}^{N - 1} C_N(k,\rho + \frac{N}{2}).P_\rho^{(1)}(m) + \sum_{\rho = 0}^{N - 1} C_N(k,\rho - \frac{N}{2})P_\rho^{(2)}(m) \quad (15)$$

En se servant des propriétés suivantes de la fonction $C_N(k, \rho)$:

$$C_N(k,\rho + \frac{N}{2}) = - C_N\left(k, N - 1 - (\rho - \frac{N}{2})\right)$$

$$C_N(k,\rho - \frac{N}{2}) = C_N\left(k, N - 1 - (\rho + \frac{N}{2})\right) \quad ,$$

on peut montrer que l'expression (15) peut s'écrire:

$$X_k(m) = \sum_{\rho = 0}^{N-1} C_N(k,\rho) \cdot P_\rho(m) \tag{16}$$

avec:

$$P_\rho(m) = P_{\frac{N}{2}-1-\rho}^{(2)}(m) + P_{\frac{N}{2}+\rho}^{(2)}(m) \quad \text{pour } 0 \leq \rho \leq \frac{N}{2} - 1$$

$$P_\rho(m) = P_{\rho-\frac{N}{2}}^{(1)}(m) - P_{\frac{3N}{2}-\rho-1}^{(1)}(m) \quad \text{pour } \frac{N}{2} \leq \rho \leq N - 1$$

On donne maintenant les résultats que l'on obtient dans les autres cas de parités de $\lambda$ et de N. $\lambda$ pair et N impair:

$$X_k(m) = \sum_{\rho = 0}^{N-1} C'_N(k,\rho) P_\rho(m)$$

$$\text{avec} \quad C'_N(k,\rho) = 2 \cos\left[\frac{(2k+1)}{2N}\rho - \Pi\right]$$

$$\text{où} \begin{cases} P_0(m) = P_{\frac{N-1}{2}}^{(2)}(m) \\[2ex] P_\rho(m) = -\left[P_{\frac{N-1}{2}-\rho}^{(2)}(m) + P_{\frac{N-1}{2}+\rho}^{(2)}(m)\right] \\[1ex] \qquad\qquad \text{pour } 1 \leq \rho \leq \frac{N-1}{2} \\[2ex] P_\rho(m) = P_{\rho-\frac{N+1}{2}}^{(1)}(m) - P_{\frac{3N-1}{2}}^{(1)}(m) \\[1ex] \qquad\qquad \text{pour } \frac{N+1}{2} \leq \rho \leq N - 1 \end{cases}$$

où $P_\rho^{(1)}$ et $P_\rho^{(2)}$ sont donnés par les formules (14). $\lambda$ impair, parité de N quelconque:

$$X_k(m) = \sum_{\rho = 0}^{N-1} C_N(k,\rho) P_\rho(m)$$

$$\text{avec } P_\rho(m) = \sum_{r = 0}^{\lambda-1} \hat{h}_\rho(r) \left[\cos\left[(2r - \lambda + 1)\frac{\Pi}{4}\right] x_\rho(m-r)\right.$$

$$+ \sin\left[(2r - \lambda + 1)\frac{\Pi}{4}\right] x_{N-1-\rho}(m-\lambda+r+1)\Big]$$

La suite de la description du banc d'analyse sera donnée à titre d'exemple dans le cas où λ et N sont pairs.

Ainsi, les calculs à effectuer dans le banc d'analyse pour obtenir les signaux de sous-bandes $x_k(m)$ peuvent être réalisés en deux parties distinctes:
- dans une première partie de filtrage, on utilise les formules (17) complétées par les formules (14) pour calculer les signaux $P_\rho(m)$ à partir des coefficients de filtrage $\hat{h}_\rho(r)$ et des échantillons $x_\rho(m-r)$ du signal entrant dans le banc d'analyse, $\hat{h}_\rho(r)$ et $x_\rho(m-r)$ étant définis dans les formules (12). Cette première partie des calculs est effectuée dans le réseau polyphasé d'analyse 12 représenté sur la figure 4a.
- dans une deuxième partie de modulation mettant en œuvre la formule (16), les signaux $P_\rho(m)$ sont modulés à l'aide d'une transformée en cosinus discrète doublement impaire ayant les coefficient définis dans la troisième formule (12). Cette deuxième étape est réalisée dans le dispositif 14.

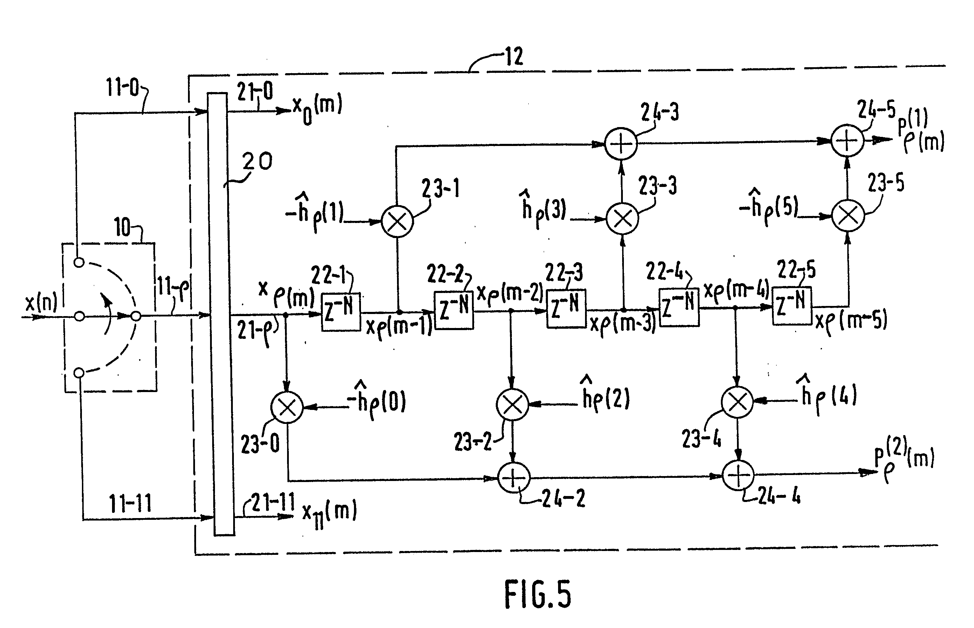

On va maintenant décrire à l'aide de la figure 5 un schéma de mise en œuvre des calculs effectués dans le réseau polyphasé 12 pour former les signaux $P_\rho^{(1)}(m)$ et $P_\rho^{(2)}(m)$. Ce schéma est donné dans le cas déjà cité où le nombre de sous-bandes à réaliser est N = 12 et le nombre de coefficients du filtre prototype est $N_c$ = 66. Pour ces valeurs de N et $N_c$, le paramètre λ défini en (10 − a) vaut 6. Ainsi, les variables ρ et r définies plus haut varient

pour ρ de 0 à 11 .
pour r de 0 à 5.

Le schéma de la figure 5 comporte le circuit commutateur 10 déjà représenté à la figure 4 qui répartit cycliquement les échantillons du signal d'entrée x(n) sur 12 branches 11 − ρ (ρ variant de 0 à 11) formant les entrées du réseau polyphasé 12. Un dispositif de décalage 20 connu en soi remet en phase les échantillons répartis dans les 12 branches d'entrées et fournit ainsi dans les branches 21 − ρ les signaux $x_\rho(m)$ ayant leurs échantillons en phase et se produisant à des instants mNT. Le schéma représente seulement le dispositif connecté à la branche 21 − ρ pour traiter le signal $x_\rho(m)$ et former les signaux $P_\rho^{(1)}(m)$ et $P_\rho^{(2)}(m)$ suivant les calculs de la formule (14), étant entendu que des dispositifs semblables doivent être connectés sur les 12 branches 21 − 0 à 21 − 11, pour former cas signaux pour toutes les valeurs de ρ.

La branche 21 − ρ est connectée à une ligne à retard formée par les circuits 22 − 1 à 22 − 5 produisant chacun un retard NT (représenté par la fonction en Z, $Z^{-N}$). A l'entrée de la ligne à retard et à la sortie des circuits 22 − 1 à 22 − 5 sont disponibles respectivement les échantillons $x_\rho(m)$ à $x_\rho(m-5)$, c'est-à-dire les échantillons $x_\rho(m-r)$ (r variant de 0 à 5) requis pour appliquer les formules (14). Ces échantillons $x_\rho(m)$ à $x_\rho(m-5)$ sont appliqués respectivement à une entrée des circuits multiplicateurs 23 − 0 à 23 − 5 pour être multipliés respectivement par les coefficients $-\hat{h}_\rho(0)$, $-\hat{h}_\rho(1)$, $-\hat{h}_\rho(2)$, $-\hat{h}_\rho(3)$, $-\hat{h}_\rho(4)$, $-\hat{h}_\rho(5)$. On peut vérifier que $-\hat{h}_\rho(1)$, $-\hat{h}_\rho(3)$, $-\hat{h}_\rho(5)$ sont les seuls termes non nuls obtenus en faisant varier r de 0 à 5 dans le facteur

$$\hat{h}_\rho(r) \cdot \cos\left((2r - \lambda)\frac{\Pi}{4}\right)$$

de la première formule (14). On peut vérifier également que $-\hat{h}_\rho(0)$, $-\hat{h}_\rho(2)$, $-\hat{h}_\rho(4)$ sont les seuls termes non nuls obtenus en faisant varier r de 0 à 5 dans le facteur

$$-\hat{h}_\rho(r)\sin\left((2r - \lambda)\frac{\Pi}{4}\right)$$

de la deuxième formule (14). Tous ces termes non nuls sont déduits des coefficients du filtre protot-pye $\hat{h}_\rho(r)$ défini ci-dessus.

En application de la première formule (14), les produits formés par les circuits multiplicateurs 23 − 1, 23 − 3 et 23 − 5 sont additionnées à l'aide des circuits additionneurs 24 − 3 et 24 − 5 et la somme ainsi obtenue constitue la valeur désirée du signal $P_\rho^{(1)}(m)$. En application de la deuxième formule (14), les produits formés par les circuits multiplicateurs 23 − 0, 23 − 2 et 23 − 4 sont additionnés à l'aide des circuits additionneurs 24 − 2 et 24 − 4 et la somme ainsi obtenu constitue la valeur désirée du signal $P_\rho^{(2)}(m)$.

On peut remarquer que la structure du réseau polyphasé de la figure 5, ayant au total 12 branches analogues à celle connectée à la branche 21 − ρ, permet d'utiliser un filtre prototype ayant jusqu'à 72 coefficients (λ · N = 72). Dans le cas envisagé où ce nombre de coefficients du filtre prototype est de 66, 6 coefficients $h_\rho(r)$ utilisés dans le réseau polyphasé seront nuls, ces coefficients nuls correspondant aux deux extrêmités de la réponse impulsionnelle du filtre prototype soient:
$\hat{h}(0) = \hat{h}_1(0) = \hat{h}_2(0) = \hat{h}_9(5) = \hat{h}_{10}(5) = \hat{h}_{11}(5) = 0$

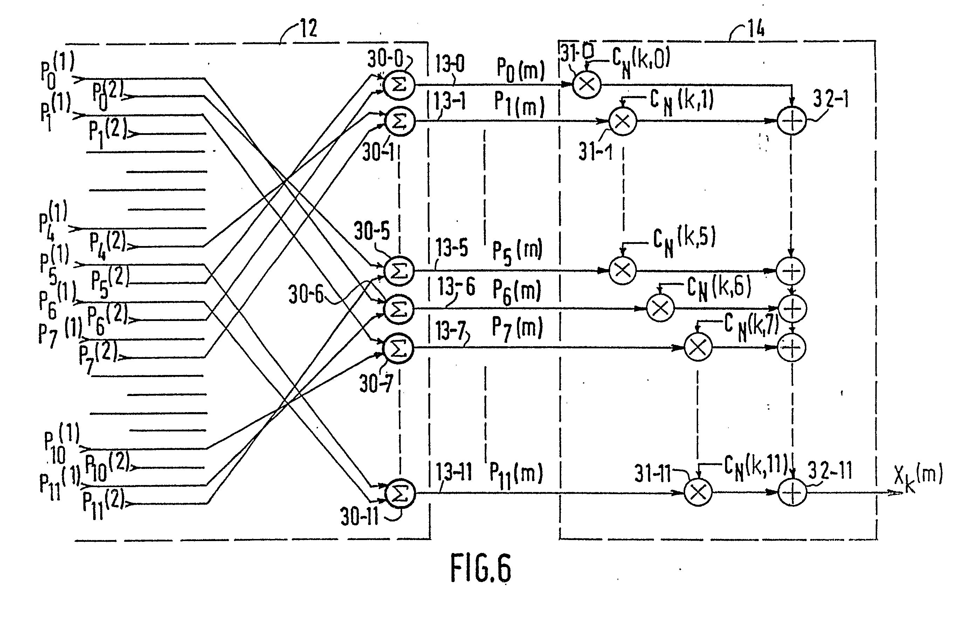

Le schéma de la figure 6 est réalisé dans le même cas que celui de la figure 5 : N = 12, $N_c$ = 66. Il comporte la partie terminale du réseau polyphasé 12 muni de 12 branches de sortie 13 − ρ et servant à former conformément aux formules (17) les 12 signaux $P_\rho(m)$ à partir des signaux $P_\rho^{(1)}(m)$ et $P_\rho^{(2)}(m)$ calculés comme on vient de l'expliquer à l'aide de la figure 5. Le schéma de la figure 6 comporte ensuite le dispositif 14 de calcul de transformée en cosinus discrète doublement impaire recevant les 12 signaux $P_\rho(m)$ et servant à former les 12 signaux de sous-bandes désirés $X_k(m)$.

Le schéma de la figure 6 représente à gauche 24 branches sur lesquelles sont appliqués les 12 couples de signaux $P_0^{(1)}(m)$ et $P_0^{(2)}(m)$. Les circuits additionneurs 30-0 à 30-5 reçoivent les signaux indiqués pour former, conformément à la première formule (17), les 6 signaux $P_0(m)$ à $P_5(m)$ à partir des 12 signaux $P_0^{(2)}$à $P_{11}^{(2)}(m)$. Les circuits soustracteurs 30-6 à 30-11 reçoivent les signaux indiqués pour former, conforméments à la deuxième formule (17), les 6 signaux $P_6(m)$ à $P_{11}(m)$ à partir des 12 signaux $P_0^{(1)}(m)$ à $P_{11}^{(1)}(m)$.

Dans le dispositif de calcul de transformée en cosinus discrète 14 mettant en œuvre la formule (16), les 12 signaux $P_0(m)$ à $P_{11}(m)$ disponibles sur les branches de sortie 13-p du réseau polyphasé 12 sont appliqués respectivement aux circuits multiplicateurs 31-0 à 31-11 pour y être multipliés respectivement par les coefficients $C_N (k, 0)$ à $C_N (k, 11)$. Ces coefficients sont déterminés à l'aide de la troisième des formules (12) et dépendent du numéro k de la sous-bande. Par les facteurs impairs $(2k+1)$ et $(2\varrho+1)$ figurant dans cette formule, les coefficients $C_N (k, \rho)$ sont caractéristiques d'une transformée en cosinus discrète doublement impaire. Les circuits additionneurs 32-1 à 32-11 sont connectés de façon à former la somme des produits fournis par les circuits multiplicateurs 31-0 à 31-11, cette somme constituant le signal $X_k(m)$ de la sous-bande k, conformément à la formule (16). Tous les signaux

de sous-bande $X_0(m)$ à $X_{11}(m)$ à fournir par le banc d'analyse sont formés de la même manière, en utilisant des coefficients $C_N(k, 0)$ à $C_N(k, 11)$ avec k variant de 0 à 11.

On va maintenant expliquer comment le banc de synthèse peut être réalisé suivant la structure de la figure 4b.

Le signal de sortie $\hat{x}(n)$ du banc de synthèse peut être considéré comme résultat de l'entrelacement de N signaux sous-échantillonnés $\hat{x}(mN + \rho)$, m caractérisant les instants d'échantillonnage se produisant à la fréquence

$$\frac{f_e}{N}$$

et $\rho$ variant de 0 à $N-1$, caractérisant chaque signal sous-échantillonné. On va essentiellement par la suite déterminer les opérations à effectuer pour obtenir chaque signal sous-échantillonné $\hat{x}(mN + \rho)$ noté $\hat{x}\rho(m)$.

Pour déterminer ces opérations, on pose comme pour le banc d'analyse, $n = rN + \rho$, r variant de 0 à $\lambda-1$, $\lambda$ étant défini comme on l'a indiqué en (10-a).

A chaque instant mNT, un signal $\hat{x}\rho (m)$ résulte de la somme de N signaux formés chacun par filtrage d'un signal de sous-bande $X_k(m)$ à l'aide de $\lambda$ coefficients d'un filtre de synthèse défini par ses coefficients $h_k(n)$. Plus précisément, un signal $\hat{x}\rho(m)$ peut être calculé selon l'expression:

$$\hat{x}_\rho(m) = \sum_{k=0}^{N-1} \sum_{r=0}^{\lambda-1} h'_k(rN+\rho) \cdot X_k(m-r) \qquad (18)$$

où $X_k(m-r)$ représente $\lambda$ échantillons fournis dans la sous-bande k, jusqu'à l'instant mNT et $h'_k(rN+\rho)$ représente un ensemble caractérisé par $\rho$ de $\lambda$ coefficients du filtre de synthèse de la sous-bande k.

En utilisant pour les coefficients $h'_k(rN+\rho)$ les

valeurs données par l'expression (3) et en utilisant les notations (12), on peut montrer, à l'aide de calculs analogues à ceux effectués pour le banc d'analyse, que l'expression (18) peut se mettre sous la forme suivante dans le cas où $\lambda$ et N sont pairs:

$$\hat{x}_\rho(m) = \sum_{r=0}^{\lambda-1} \hat{h}_\rho(r) \left[ \cos\left((2r-\lambda)\frac{\Pi}{4}\right) \cdot Y_{\frac{N}{2}-1-\rho}^{(m-r)} + \sin\left((2r-\lambda)\frac{\Pi}{4}\right) \cdot Y_{\frac{N}{2}+\rho}^{(m-r)} \right] \qquad (19)$$

pour $0 \leqslant \rho \leqslant \frac{N}{2} - 1$

$$\hat{x}_\rho(m) = \sum_{r=0}^{\lambda-1} \hat{h}_\rho(r) \left[ \cos\left((2r-\lambda)\frac{\Pi}{4}\right) \cdot Y_{\rho-\frac{N}{2}}^{(m-r)} - \sin\left((2r-\lambda)\frac{\Pi}{4}\right) \cdot Y_{\frac{3N}{2}-\rho-1}^{(m-r)} \right] \qquad (20)$$

pour $\frac{N}{2} \leqslant \rho \leqslant N - 1$

avec $Y_\rho(m) = \sum_{k=0}^{N-1} C_N(k,\rho) \cdot X_k(m) \qquad (21)$

En se servant de la symétrie du filtre prototype $h(n)$ qui s'exprime par $\hat{h}(r) = \hat{h}_{N-1-\varrho}(\lambda - r - 1)$, l'expression (20) peut s'écrire:

$$\hat{x}^{(m)}_{N-1-\rho} = \sum_{r=0}^{\lambda-1} \hat{h}_\rho(r) \left[ \cos\left((\lambda - 2r - 2)\frac{\Pi}{4}\right) \cdot Y^{(m-\lambda+r+1)}_{\frac{N}{2}-1-\rho} - \sin\left((\lambda - 2r - 2)\frac{\Pi}{4}\right) \right.$$

$$\left. \cdot Y^{(m-\lambda+r+1)}_{\frac{N}{2}+\rho} \right] \qquad\qquad (22)$$

pour $0 \leqslant \rho \leqslant \frac{N}{2} - 1$

On donne ci-dessous les résultats que l'on obtient dans les autres cas de parités de $\lambda$ et de N:

$\lambda$ pair et N impair:

$$\hat{x}_\rho(m) = \sum_{r=0}^{\lambda-1} \hat{h}_\rho(r) \left[ \cos\left((2r - \lambda)\frac{\Pi}{4}\right) y_{\frac{N-1}{2}-\rho}(m-r) \right.$$

$$\left. + \sin\left((2r - \lambda)\frac{\Pi}{4}\right) y_{\rho+\frac{N+1}{2}}(m-r) \right]$$

pour $0 \leqslant \rho \leqslant \frac{N-1}{2}$

avec $y_N(m) = 0$ quel que soit m

$$\hat{x}_\rho(m) = \sum_{r=0}^{\lambda-1} \hat{h}_\rho(r) \left[ \cos\left((2r - \lambda)\frac{\Pi}{4}\right) y_{\rho-\frac{N-1}{2}}(m-r) \right.$$

$$\left. - \sin\left((2r - \lambda)\frac{\Pi}{4}\right) y_{\frac{3N-1}{2}-\rho}(m-r) \right]$$

pour $\frac{N+1}{2} \leqslant \rho \leqslant N - 1$

avec $y_\rho(m) = \sum_{k=0}^{N-1} C'_N(k,\rho) X_k(m)$

où $C'_N(k,\rho) = 2\cos\left[ \frac{(2k+1)}{2N} \rho - \Pi \right]$

. $\lambda$ impair, parité de N quelconque :

$$\hat{x}_\rho(m) = \sum_{r=0}^{\lambda-1} \hat{h}_\rho(r) \left[ \cos\left((2r - \lambda - 1)\frac{\Pi}{4}\right) y_\rho(m-r) \right.$$

$$- \sin\left((2r - \lambda - 1)\frac{\Pi}{4}\right) y_{N-1-\rho}(m-r)\Bigg]$$

avec $y_\rho(m)$ donné par l'expression (21). Comme pour le banc d'analyse, la suite de la description du banc de synthèse sera donnée dans le cas où $\lambda$ et N sont pairs.

Ainsi, les calculs à effectuer dans le banc de synthèse pour obtenir le signal de sortie $\hat{x}(n)$ peuvent être réalisés en deux parties distinctes:
- dans une première partie de modulation mettant en œuvre la formule (21), les signaux de sous-bande $X_k(m)$ sont modulés à l'aide d'une transformée en cosinus discrète doublement impaire pour former les signaux $Y_\rho(m)$. Cette première partie est réalisée dans le dispositif de calcul 15 de la figure 4b.
- dans une deuxième partie de filtrage, on utilise les formules (19) et (20) ou (22) pour calculer les signaux $\hat{x}_\rho(m)$ à partir des coefficients de filtrage $\hat{h}_\rho(r)$ et des signaux $y_\rho(m)$ fournis par la première partie. Cette deuxième partie est réalisée dans le réseau polyphasé de synthèse 17 de la figure 4b. Le signal de sortie $\hat{x}(n)$ est obtenu en répartissant dans le temps les signaux $\hat{x}_\rho(m)$.

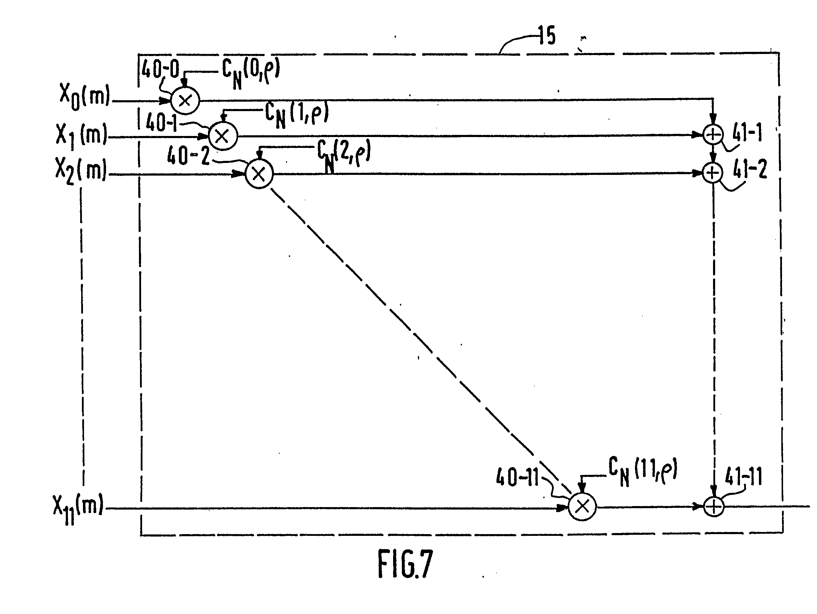

On va maintenant décrire à l'aide de la figure 7, un schéma de réalisation du dispositif 15 de calcul de transformée en cosinus doublement impaire dans le cas précité ou N = 12 et $\lambda$ = 5 de sorte que la variable $\rho$ varie de 0 à 6 et la variable r varie de 0 à 11.

Selon la figure 7, le dispositif 15 comporte 12 branches d'entrée qui reçoivent respectivement les signaux de sous-bande $X_0(m)$ à $X_{11}(m)$. Ces 12 signaux de sous-bande sont appliqués respectivement aux circuits multiplicateurs $40-0$ à $40-11$ pour y être multipliés par les coefficients $C_N(0, \rho)$ à $C_N(11, \rho)$ déterminés par la troisième des formules (12). Les circuits additionneurs $41-1$ à $41-11$ sont connectés de façon à former la somme des signaux fournis par les circuits multiplicateurs $40-0$ à $40-11$, cette somme constituant le signal $y_\rho(m)$ déterminé conformément à la formule (21). En utilisant les coefficients $C_N(0, \rho)$ à $C_N(11, \rho)$ pour $\rho$ variant de 0 à 11, on obtient 12 signaux $Y_0(m)$ et $y_{11}(m)$. On peut remarquer que les dispositifs 14 et 15 des bancs d'analyse et de synthèse ont la même structure et utilisent le même ensemble de coefficients $C_N(k, \rho)$ caractéristiques d'une transformée en cosinus discrète doublement impaire.

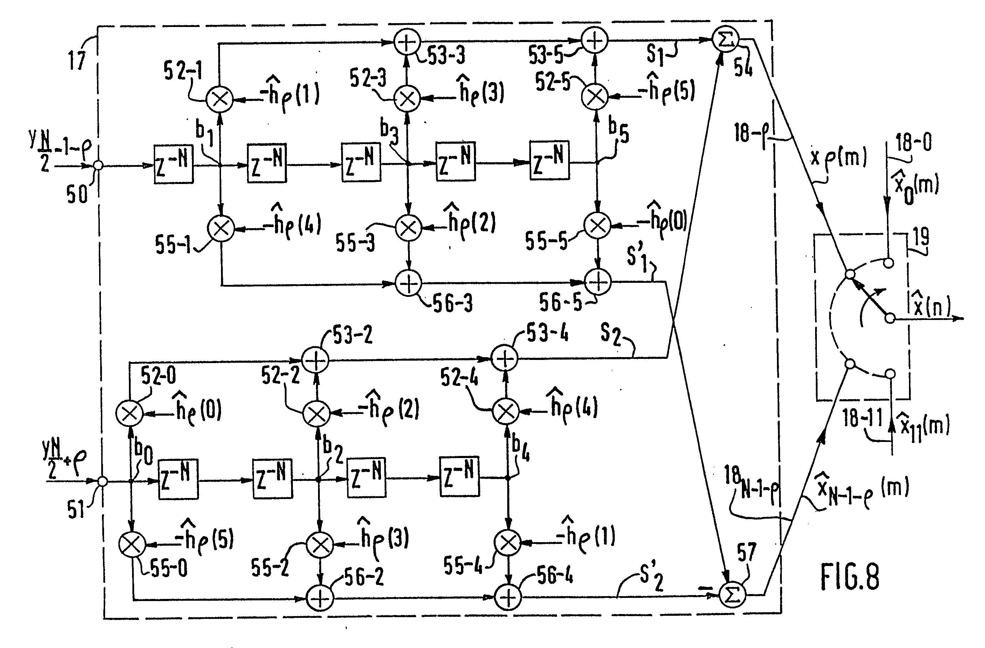

Le schéma de la figure 8 met en œuvre dans le réseau polyphasé 17 les calculs donnés par les expressions (19) et (22), dans le cas où N = 12 et $\lambda$ = 6. L'utilisation des formules (19) et (22) permet d'obtenir pour la même valeur de $\rho$ allant de

$$0 \text{ à } \frac{N}{2} - 1 \quad (0 \text{ à } 5),$$

les deux signaux $\hat{x}_\rho(m)$ et

Le schéma du réseau polyphasé 17 donnée pour la valeur courante de $\rho$ (variant de 0 à 5) comporte deux entrées 50 et 51 recevant respectivement du dispositif 15 les signaux

$$Y_{\frac{N}{2}-1-\rho}(m) \; ,$$

soit $Y_{5-\rho}(m)$, et

$$Y_{\frac{N}{2}+\rho}(m),$$

soit $Y_{6+\rho}(m)$. A l'entrée 50 est connectée une ligne à retard formée de 5 éléments produisant chacun un retard NT et à l'entrée 51 est connectée une ligne à retard formée de 4 éléments produisant chacun un retard NT. Aux points $b_1$, $b_3$, $b_5$ de la ligne à retard connectée à l'entrée 50 se trouvent respectivement les échantillons

$$Y_{\frac{N}{2}-1-\rho}(m-1) \; , \quad Y_{\frac{N}{2}-1-\rho}(m-3), \quad Y_{\frac{N}{2}-1-\rho}(m-5) \; ,$$

représentables par

$$Y_{\frac{N}{2}-1-\rho}(m-r) \; ,$$

pour r = 1, 3, 5. Au points $b_0$, $b_2$, $b_4$ de la ligne à retard connectée à 51 se trouvent respectivement les échantillons

$$Y_{\frac{N}{2}+\rho}(m) \; , \quad Y_{\frac{N}{2}+\rho}(m-2), \quad Y_{\frac{N}{2}+\rho}(m-4) \; ,$$

représentables par

$$Y_{\frac{N}{2}+\rho}(m-r) \quad pour \quad r = 0, \; 2, \; 4.$$

Les points $b_1$, $b_3$, $b_5$ sont connectés respectivement à une entrée des circuits multiplicateurs $51-1$, $52-3$, $52-5$. L'autre entrée de ces circuits multiplicateurs reçoit les coefficients $-\hat{h}_\rho(1)$, $\hat{h}_\rho(3)$, $-\hat{h}_\rho(5)$ qui représentent les termes non nuls

$$\hat{h}_\rho(r) . \cos\left((2r - \lambda)\frac{\Pi}{4}\right)$$

apparaissant dans la formule (19), pour r variant de 0 à $\lambda-1$, soit 0 à 5. Les circuits multiplicateurs $52-1$, $52-3$, $52-5$ fournissent des produits qui sont additionnées à l'aide de circuits additionneurs $53-3$, $53-5$ pour former la première som-

me $S_1$ permettant de calculer $\hat{x}_\rho(m)$ selon la formule (19), soit:

$$S_1 = \sum_{r=0}^{\lambda-1} \hat{h}_\rho(r) \cos\left((2r - \lambda)\frac{\Pi}{4}\right) \cdot Y_{\frac{N}{2}-1-\rho}(m-r).$$

Par ailleurs les points $b_0$, $b_2$, $b_4$ sont connectés respectivement à une entrée des circuits multiplicateurs 52−0, 52−2, 52−4. L'autre entrée de ces circuits multiplicateurs reçoit les coefficients $\hat{h}_\rho(0)$, $-\hat{h}_\rho(2)$, $\hat{h}_\rho(4)$ qui représentent les termes non nuls

$$\hat{h}_\rho(r) \cdot \sin\left((2r - \lambda)\frac{\Pi}{4}\right)$$

$$S_2 = \sum_{r=0}^{\lambda-1} \hat{h}_\rho(r) \sin\left((2r - \lambda)\frac{\Pi}{4}\right) \cdot Y_{\frac{N}{2}+\rho}(m-r)$$

Le circuit additionneur 54 forme la somme $S_1 + S_2$ qui constitue le signal $x_\rho(m)$ apparaissant sur la branche de sortie 18−$\rho$ du réseau polyphasé de synthèse.

D'autre part, les échantillons

$$Y_{\frac{N}{2}-1-\rho}(m-5), \qquad Y_{\frac{N}{2}-1-\rho}(m-3), \qquad Y_{\frac{N}{2}-1-\rho}(m-1)$$

apparaissant sur les points $b_5$, $b_3$, $b_1$ de la ligne à retard connectée à 50 peuvent aussi être représentés par

$$Y_{\frac{N}{2}-1-\rho}(m-\lambda+r+1) \quad \text{soit} \quad Y_{\frac{N}{2}-1-\rho}(m-5+r)$$

pour $r = 0, 2, 4$. De même, les échantillons

$$Y_{\frac{N}{2}+\rho}(m-4) \qquad Y_{\frac{N}{2}+\rho}(m-2), Y_{\frac{N}{2}+\rho}(m)$$

apparaissant sur les points $b_4$, $b_2$, $b_0$ de la ligne à

$$S'1 = \sum_{r=0}^{\lambda-1} \hat{h}_\rho(r) \cdot \cos\left((\lambda - 2r - 2)\frac{\Pi}{4}\right) \cdot Y_{\frac{N}{2}-1-\rho}(m-\lambda+r+1)$$

D'autre part, les points $b_4$, $b_2$, $b_0$ sont connectés à une entrée des circuits multiplicateurs 55−4, 55−2, 55−0 dont l'autre entrée reçoit les coefficients $-\hat{h}_\rho(1)$, $\hat{h}_\rho(3)$, $-\hat{h}_\rho(5)$. Les produits formés par ces circuits multiplicateurs sont additionnés à l'aide des circuits addionneurs 56−2, 56−4 pour former le signal S'2. On peut vérifier aisément

$$S'2 = \sum_{r=0}^{\lambda-1} \hat{h}_\rho(r) \cdot \sin\left((\lambda - 2r - 2)\frac{\Pi}{4}\right) \cdot Y_{\frac{N}{2}+\rho}(m-\lambda+r+1)$$

apparaissant dans la formule (19), pour r variant de 0 à $\lambda-1$, soit 0 à 5. Les circuits multiplicateurs 52−0, 52−2, 52−4 fournissent des produits qui sont additionnés à l'aide des circuits additionneurs 53−2, 53−4 pour former la deuxième somme $S_2$ permettant de calculer $\hat{x}_\rho(m)$ selon la formule (19), soit:

retard connectée à 51 peuvent aussi être représentée par

$$Y_{\frac{N}{2}+\rho}(m-5+r)$$

pour $r = 1, 3, 5$. Les points $b_5$, $b_3$, $b_1$ sont connectés à une entrée des circuits multiplicateurs 55−5, 55−3, 55−1 dont l'autre entrée reçoit les coefficients $-\hat{h}_\rho(0)$, $\hat{h}_\rho(2)$, $-\hat{h}_\rho(4)$. Les produits formés par ces circuits multiplicateurs sont additionnés à l'aide des circuits additionneurs 56−3, 56−5 pour former le signal S'1. On peut vérifier aisément que S'1 est la première somme permettant de calculer

$$\hat{x}_{N-1-\rho}(m)$$

selon la formule (22), soit:

que S'2 est la deuxième somme permettant de calculer

$$\hat{x}_{N-1-\rho}(m)$$

selon la formule (22), soit:

Le circuit soustracteur 57 forme la différence $S'1 - S'2$ qui constitue le signal

$$\hat{x}_{N-1-\rho}(m)$$

apparaissant sur la branche de sortie $18_{N-1-\rho}$ du réseau polyphasé de synthèse.

Les calculs de $\hat{x}_\rho(m)$ et de

$$\hat{x}_\rho(m) \quad \text{et de} \quad \hat{x}_{N-1-\rho}(m)$$

sont mis en œuvre dans le réseau polyphasé de synthèse pour

$$\frac{N}{2}$$

valeurs de $\rho$ allant de

$$0 \quad \text{à} \quad \frac{N}{2} - 1$$

(soit 6 valeurs de $\rho$ allant de 0 à 5), ce qui permet d'obtenir sur les $N = 12$ branches de sortie du réseau polyphasé $18-0$ à $18-11$, les signaux sous échantillonnés $\hat{x}_0(m)$ à $\hat{x}_{11}(m)$ qui sont répartis dans le temps à l'aide du circuit commutateur 19, pour former le signal de sortie $\hat{x}(n)$ du banc de synthèse.

Avec le système complet de bancs d'analyse et de synthèse réalisés chacun avec un réseau polyphasé et un dispositif de calcul de transformée en cosinus discrète, le nombre de multiplications par seconde se réduit à

$$2(\frac{N_c}{N} + N)f_e,$$

soit 140000 pour $N = 12$ et $N_c = 66$ et le nombre d'additions par seconde se réduit à

$$2(\frac{N_c}{N} + N - 2)f_e,$$

soit 124000.

## Revendications

1. Système de traitement numérique de signal comprenant un banc de filtres d'analyse (12, 14) pour décomposer un signal entrant échantillonné à la fréquence $f_e$ et occupant une bande de fréquences limitée à $f_e/2$, en N signaux de sous-bandes contigües de largeur $f_e/2N$, échantillonnés à la fréquence $f_e/N$, un banc de filtres de synthèse (15, 17) pour reconstituer ledit signal entrant à partir desdits signaux de sous-bandes, lesdits bancs de filtres étant formés par modulation d'un filtre prototype passe-bas ayant une réponse impulsionnelle finie et symétrique, une fréquence $f_a$ de début de bande atténuée inférieure à $f_e/2N$ et répondant à la condition $H^2(f) + H^2(f_e/2N - f) = 1$ dans la bande de fréquence f allant de 0 à $f_a$, $H(f)$ étant le module de la réponse en fréquence, la modulation du filtre prototype étant réalisée par N signaux de modulation sinusoïdaux caractérisés, pour former la Kième sous-bande (k allant de 0 à $N - 1$), par la fréquence

$$f_k = \frac{f_e}{4N}(2k + 1),$$

par la phase $\alpha_k$ pour le banc d'analyse et la phase $-\alpha_k$ pour le banc de synthèse, la phase $\alpha_k$ étant telle que pour la sous-bande d'ordre

$$k = 0, \alpha_o = \frac{\Pi}{4}, \frac{3\Pi}{4}, \frac{5\Pi}{4} \quad \text{ou} \quad \frac{7\Pi}{4}$$

et telle que pour deux sous-bandes contigües d'ordres

$$k \text{ et } k-1, \alpha_k - \alpha_{k-1} = \frac{\Pi}{2} \text{ ou } -\frac{\Pi}{2},$$

caractérisé en ce que lesdits signaux de modulation sont en outre retardés du temps

$$\tau = \frac{N_c - 1}{2} \cdot \frac{1}{f_e}, \quad N_c$$

étant le nombre de coefficients requis pour réaliser les caractéristiques du filtre prototype.

2. Système selon la revendication 1, caractérisé en ce que le banc d'analyse est formé par:
- un réseau polyphasé à N branches (12) sur lesquelles sont répartis à chaque période NT, N échantillons du signal entrant dans le banc d'analyse, ce réseau polyphasé étant agencé pour calculer à chaque période NT caractérisée par m et pour chacune de ses branches caractérisée par $\rho$ (variant de 0 à $N - 1$) un signal $P_\rho(m)$ formé à partir de coefficients du filtre prototype et de $\lambda$ échantillons consécutifs entrés dans la branche, étant la valeur entière de

$$\frac{N + N_c - 1}{N},$$

- un dispositif de calcul (14) de transformée en cosinus discrète doublement impaire recevant les N signaux $P_\rho(m)$ fournis par le réseau polyphasé et agencé pour calculer les N signaux de sous-bande $X_k(m)$ suivant une expression dépendant des parités de $\lambda$ et de N:
pour $\lambda$ impair et pour $\lambda$ pair et N pair:

$$X(m) = \sum_{\rho = 0}^{N - 1} C_N(k, \rho) \cdot P_\rho(m)$$

avec :

$$C_N(k,\rho) = 2 \cos\left[\frac{(2k + 1)(2\rho + 1)}{4N}\Pi\right] .$$

. pour $\lambda$ pair et N impair :

$$X_k(m) = \sum_{\rho = 0}^{N - 1} C'_N(k,\rho).P_\rho(m)$$

avec :

$$C'_N(k,\rho) = 2 \cos\left[\frac{2(k+1)\rho}{2N} \Pi\right] .$$

3. Système selon la revendication 2, caractérisé en ce que le réseau polyphasé du banc d'analyse est agencé pour calculer chaque signal $P_\rho(m)$ selon une expression dépendant des parités de $\lambda$ et N:

pour $\lambda$ pair et N pair:

$$\begin{cases} P_\rho(m) = P^{(2)}_{\frac{N}{2}-1-\rho}(m) + P^{(2)}_{\frac{N}{2}+\rho}(m) & \text{pour } 0 \leqslant \rho \leqslant \frac{N}{2} - 1 \\[2em] P_\rho(m) = P^{(1)}_{\rho-\frac{N}{2}}(m) - P^{(1)}_{\frac{3N}{2}-\rho-1}(m) & \text{pour } \frac{N}{2} \leqslant \rho \leqslant N - 1 \end{cases}$$

avec $$\begin{cases} P^{(1)}_\rho(m) = \sum_{r = 0}^{\lambda - 1} \widehat{h}_\rho(r)\cos\left((2r - \lambda)\frac{\Pi}{4}\right).x_\rho(m-r) \\[2em] P^{(2)}_\rho(m) = \sum_{r = 0}^{\lambda - 1} \widehat{h}_\rho(r)\sin\left((2r - \lambda)\frac{\Pi}{4}\right).x_\rho(m-r) . \end{cases}$$

pour $\lambda$ pair et N impair:

$$P_0(m) = P^{(2)}_{\frac{N-1}{2}}(m)$$

$$P_\rho(m) = -\left[P^{(2)}_{\frac{N-1}{2}-\rho}(m) + P^{(2)}_{\frac{N-1}{2}+\rho}(m)\right] \quad \text{pour } 1 \leqslant \rho \leqslant \frac{N - 1}{2}$$

$$P_\rho(m) = P^{(1)}_{\rho-\frac{N+1}{2}}(m) - P^{(1)}_{\frac{3N-1}{2}-\rho}(m) \quad \text{pour } \frac{N + 1}{2} \leqslant \rho \leqslant N - 1$$

pour $\lambda$ impair :

$$P_\rho(m) = \sum_{r=0}^{\lambda-1} \hat{h}_\rho(r) \left[ \cos\left((2r - \lambda + 1)\frac{\Pi}{4}\right) x_\rho(m-r) \right.$$

$$\left. + \sin\left((2r - \lambda + 1)\frac{\Pi}{4}\right) x_{N-1-\rho}(m-\lambda+r+1) \right]$$

$\hat{h}_\rho(r)$ représentant $\lambda$ coefficients $h(n)$ du filtre prototpye pour $n = rN + \rho$, $x_\rho(m-r)$ représentant $\lambda$ échantillons entrés dans une branche $\rho$ du réseau polyphasé jusqu'à ladite période NT caractérisée par m.

4. Système selon l'une des revendications 1 à 3, caractérisé en ce que le banc de synthèse est formé par:

– un dispositif (15) de calcul de transformée en cosinus discrète doublement impaire recevant N signaux de sous-bande $X_k(m)$ et agencé pour calculer N signaux $Y_\rho(m)$ suivant une expression dépendant des parités de $\lambda$ et N:

pour $\lambda$ impair et pour $\lambda$ pair et N pair:

$$Y_\rho(m) = \sum_{k=0}^{N-1} C_N(k, \rho) \cdot X_k(m)$$

pour $\lambda$ impair et pour $\lambda$ pair et N pair:

$$y_\rho(m) = \sum_{k=0}^{N-1} C'_N(k, \rho) \cdot x_k(m)$$

– un réseau (17) polyphasé à N branches recevant les signaux $Y_\rho(m)$ et agencé pour calculer à chaque période NT caractérisée par m et pour chaque branche caractérisée par $\rho$, un signal $\hat{x}_\rho(m)$ formé à partir de $\lambda$ coefficients du filtre prototype et de échantillons consécutifs de $Y_\rho(m)$ entrés dans la branche, les N échantillons de $\hat{x}_\rho(m)$ formés au cours de chaque période NT étant répartis dans le temps pour former le signal de sortie du banc de synthèse.

5. Système selon la revendication 4, caractérisé en ce que le réseau polyphasé du banc de synthèse est agencé pour calculer le signal $\hat{x}_\rho(m)$, suivant une expression dépendant des parités de $\lambda$ et N:

pour $\lambda$ pair et N pair:

$$\hat{x}_\rho(m) = \sum_{r=0}^{\lambda-1} \hat{h}_\rho(r) \left[ \cos\left((2r - \lambda)\frac{\Pi}{4}\right) \cdot Y_{\frac{N}{2}-1-\rho}(m-r) \right.$$

$$\left. + \sin\left((2r - \lambda)\frac{\Pi}{4}\right) \cdot Y_{\frac{N}{2}+\rho}(m-r) \right]$$

$$\hat{x}_{N-1-\rho}(m) = \sum_{r=0}^{\lambda-1} \hat{h}_\rho(r) \left[ \cos\left((2r - \lambda - 2)\frac{\Pi}{4}\right) \cdot Y_{\frac{N}{2}-1-\rho}(m-\lambda+r+1) \right.$$

$$\left. - \sin\left((2r - \lambda - 2)\frac{\Pi}{4}\right) \cdot Y_{\frac{N}{2}+\rho}(m-\lambda+r+1) \right]$$

$$\text{avec } 0 \leqslant \rho \leqslant \frac{N}{2} - 1$$

. pour $\lambda$ pair et N impair :

$$\hat{x}_\rho(m) = \sum_{r=0}^{\lambda-1} \hat{h}_\rho(r)\left[\cos\left((2r-\lambda)\frac{\Pi}{4}\right) y_{\frac{N-1}{2}-\rho}(m-r)\right.$$

$$\left. + \sin\left((2r-\lambda)\frac{\Pi}{4}\right) y_{\rho+\frac{N+1}{2}}(m-r)\right]$$

$$\text{pour } 0 \leqslant \rho \leqslant \frac{N-1}{2}$$

$$\hat{x}_\rho(m) = \sum_{r=0}^{\lambda-1} \hat{h}_\rho(r)\left[\cos\left((2r-\lambda)\frac{\Pi}{4}\right) y_{\rho-\frac{N-1}{2}}(m-r)\right.$$

$$\left. - \sin\left((2r-\lambda)\frac{\Pi}{4}\right) y_{\frac{3N-1}{2}}(m-r)\right]$$

$$\text{pour } \frac{N+1}{2} \leqslant \rho \leqslant N-1$$

$$\text{avec } y_N(m) = 0 \text{ quel que soit } m$$

. pour $\lambda$ impair :

$$\hat{x}_\rho(m) = \sum_{r=0}^{\lambda-1} \hat{h}_\rho(r)\left[\cos\left((2r-\lambda-1)\frac{\Pi}{4}\right) y_\rho(m-r)\right.$$

$$\left. - \sin\left((2r-\lambda-1)\frac{\Pi}{4}\right) y_{N-1-\rho}(m-r)\right]$$

$$\text{pour } 0 \leqslant \rho \leqslant N-1.$$

## Patentansprüche

1. Digitales Signalverarbeitungssystem mit einer Analysenfilterbank (12, 14) zum Aufteilen eines mit der Frequenz $f_e$ abgetasteten und ein auf $f_e/2$ begrenztes Frequenzband belegenden eintreffenden Signals in N angrenzende mit einer Frequenz $f_e/N$ abgetastete Teilbandsignale mit einer Bandbreite von $f_e/2N$, weiterhin mit einer Synthesefilterbank (15, 17) zum Wiederherstellen des genannten eintreffenden Signals aus den genannten Teilbandsignalen, wobei die genannten Filterbänke durch Modulation eines Tiefpass-Prototypfilters gebildet werden mit einer endlichen und symmetrischen Stossantwort und mit einer Anfangsfrequenz $f_a$ des Dämpfungsbandes, die niedriger ist als $f_e/2N$ und die Bedingung $H^2(f) + H^2(f_e/2N - f) = 1$ in dem Band der Frequenze f von 0 bis $f_a$ erfüllt, wobei H (f) der Absolutwert des Frequenzganges ist, wobei die Modulation des Prototyp-Filters durch N sinusförmige Modulationssignale erfolgt, die zum Bilden des k.

Teilbandes (wobei k sich von 0 bis N − 1 erstreckt) durch die Frequenz $f_k = (f_e/4N)(2k+1)$, durch die Phase $\alpha_k$ für die Analysenfilterbank und durch die Phase $-\alpha_k$ für die Synthesefilterbank gekennzeichnet sind, wobei die Phase $\alpha_k$ derart ist, dass für das Teilband der Ordnung k = 0, $\alpha_0 = \pi/4$, $3\pi/4$, $5\pi/4$ oder $7\pi/4$ ist und dass für zwei angrenzende Teilbänder der Ordnung k und k−1, $\alpha_k - \alpha_{k-1} = \pi/2$ oder $-\pi/2$ ist, dadurch gekennzeichnet, dass die genannten Modulationssignale ausserdem um $\tau = (N_c-1)/(2f_e)$ verzögert sind, wobei $N_c$ die Zahl der Koeffizienten ist zum Verwirklichen der Kennlinien des Prototyp-Filters.

2. System nach Anspruch 1, dadurch gekennzeichnet, dass die Analysenfilterbank gebildet wird durch:
- ein Polyphasennetzwerk mit N Zweigen (12), über die in jeder Periode NT N Abtastwerte des bei der Analysenfilterbank eintreffenden Signals verteilt sind, wobei dieses Polyphasennetzwerk dazu vorgesehen ist, in jeder durch m gekennzeichneten Periode NT und für jeden der durch $\rho$

gekennzeichneten Zweige (wobei $\rho$ von 0 bis $N-1$ variiert), ein Signal $P_\rho(m)$ zu berechnen, dass aus den Koeffizienten des Prototypfilters und den $\lambda$ aufeinanderfolgenden an dem Zweig eingetroffenen Abtastwerten gebildet ist, wobei $\lambda$ der ganzzahlige Teil von $(N+N_c-1)/N$ ist,
– eine Rechenordnung (14) zum Berechnen der doppel-ungeraden diskreten Kosinustransformierten, wobei diese Anordnung bis N Signale $P_\rho(m)$ erhält, die von dem Polyphasennetzwerk geliefert werden, und angeordnet ist zum Berechnen der N Signale des Teilbandes $X_k(m)$ entsprechend einem Ausdruck abhängig von der Paritäten von $\lambda$ und N:
für $\lambda$ ungerade und für $\lambda$ gerade und N gerade:

$$X(m) = \sum_{\rho=0}^{N-1} C_N(k,\rho) \cdot P_\rho(m)$$

wobei

$$C_N(k,\rho) = 2 \cos\left[\frac{(2k+1)(2\rho+1)}{4N}\pi\right] .$$

Für $\lambda$ gerade und N ungerade:

$$X_k(m) = \sum_{\rho=0}^{N-1} C'_N(k,\rho) \cdot P_\rho(m)$$

wobei

$$C'_N(k,\rho) = 2 \cos\left[\frac{2(k+1)\rho}{2N}\pi\right]$$

3. System nach Anspruch 2, dadurch gekennzeichnet, dass das Polyphasennetzwerk der Analysenfilterbank angeordnet ist zum Berechnen je- des Signals $P_\rho(m)$ entsprechend einem Ausdruck abhängig von der Paritäten von $\lambda$ und N:
für $\lambda$ gerade und N gerade:

$$\begin{cases} P_\rho(m) = P^{(2)}_{\frac{N}{2}-1-\rho}(m) + P^{(2)}_{\frac{N}{2}+\rho}(m) & \text{für } 0 \leq \rho \leq \frac{N}{2}-1 \\[2em] P_\rho(m) = P^{(1)}_{\rho-\frac{N}{2}}(m) - P^{(1)}_{\frac{3N}{2}-\rho-1}(m) & \text{für } \frac{N}{2} \leq \rho \leq N-1 \end{cases}$$

wobei

$$\begin{cases} P^{(1)}_\rho(m) = \sum_{r=0}^{\lambda-1} \widehat{h}_\rho(r) \cos\left((2r-\lambda)\frac{\pi}{4}\right) \cdot x_\rho(m-r) \\[2em] P^{(2)}_\rho(m) = \sum_{r=0}^{\lambda-1} \widehat{h}_\rho(r) \sin\left((2r-\lambda)\frac{\pi}{4}\right) \cdot x_\rho(m-r) . \end{cases}$$

für λ gerade und N ungerade:

$$P_0(m) = P^{(2)}_{\frac{N-1}{2}}(m)$$

$$P_\rho(m) = -\left[P^{(2)}_{\frac{N-1}{2}-\rho}(m) + P^{(2)}_{\frac{N-1}{2}+\rho}(m)\right] \quad \text{für } 1 \le \rho \le \frac{N-1}{2}$$

$$P_\rho(m) = P^{(1)}_{\rho-\frac{N+1}{2}}(m) - P^{(1)}_{\frac{3N-1}{2}-\rho}(m) \quad \text{für } \frac{N+1}{2} \le \rho \le N-1$$

für λ ungerade:

$$P_\rho(m) = \sum_{r=0}^{\lambda-1} \hat{h}_\rho(r)\left[\cos\left((2r-\lambda+1)\frac{\pi}{4}\right)x_\rho(m-r) + \sin\left((2r-\lambda+1)\frac{\pi}{4}\right)x_{N-1-\rho}(m-\lambda+r+1)\right]$$

wobei $\hat{h}_\rho(r)$ λ Koeffizienten $h(n)$ des Prototypfilters für $n = rN+\rho$ darstellt, $x_\rho(m-r)$ λ Abtastwerte darstellt, die in einem Zweig p des Polyphasennetzwerkes bis zu der genannten, durch m bezeichneten Periode NT eingetroffen sind.

4. System nach einem der Ansprüche 1 bis 3, dadurch gekennzeichnet, dass die Synthesefilterbank gebildet ist durch:
– eine Rechenanordnung (15) zum Berechnen der doppelungeraden diskreten Kosinustransformierten, die N Teilbandsignale $X_k(m)$ erhält und dazu vorgesehen ist, N Signale $Y_\rho(m)$ zu berechnen entsprechend einem Ausdruck abhängig von der Paritäten von λ und N:
für λ ungerade und für λ gerade und N gerade:

$$Y_\rho(m) = \sum_{k=0}^{N-1} C_N(k,\rho)\cdot X_k(m)$$

für λ gerade und N ungerade:

$$Y_\rho(m) = \sum_{k=0}^{N-1} C'_N(k,\rho)\cdot x_k(m)$$

– ein Polyphasennetzwerk (17) mit N Zweigen, das die Signale $Y_\rho(m)$ erhält und dazu vorgesehen ist, zu jeder durch m bezeichneten Periode und für jeden durch p bezeichneten Zweig ein Signal $\hat{x}_\rho(m)$ zu berechnen, das aus λ Koeffizienten des Prototypfilters und aufeinanderfolgenden Abtastwerten von $Y_\rho(m)$, die in den Zweig eingetroffen sind, wobei die N Abtastwerte von $\hat{x}_\rho(m)$, die während jeder Periode NT gebildet werden, zum Erzeugen des Ausgangssignals der Synthesefilterbank zeitverteilt werden.

5. System nach Anspruch 4, dadurch gekennzeichnet, dass das Polyphasennetzwerk vorgesehen ist zum Berechnen des Signals $\hat{x}_\rho(m)$, entsprechend einem Ausdruck abhängig von der Paritäten von λ und N:
für λ gerade und N ungerade:

$$\hat{x}_\rho(m) = \sum_{r=0}^{\lambda-1} \hat{h}_\rho(r)\left[\cos\left((2r-\lambda)\frac{\pi}{4}\right)\cdot Y_{\frac{N}{2}-1-\rho}(m-r) + \sin\left((2r-\lambda)\frac{\pi}{4}\right)\cdot Y_{\frac{N}{2}+\rho}(m-r)\right]$$

$$\hat{x}^{(m)}_{N-1-\rho} = \sum_{r=0}^{\lambda-1} \hat{h}_\rho(r) \left[ \cos\left((2r-\lambda-2)\frac{\pi}{4}\right) \cdot Y_{\frac{N}{2}-1-\rho}(m-\lambda+r+1) \right.$$

$$\left. - \sin\left((2r-\lambda-2)\frac{\pi}{4}\right) \cdot Y_{\frac{N}{2}+\rho}(m-\lambda+r+1) \right]$$

wobei

$$0 \leqslant \rho \leqslant \frac{N}{2} - 1$$

für λ gerade und N ungerade:

$$\hat{x}_\rho(m) = \sum_{r=0}^{\lambda-1} \hat{h}_\rho(r) \left[ \cos\left((2r-\lambda)\frac{\pi}{4}\right) y_{\frac{N-1}{2}-\rho}(m-r) \right.$$

$$\left. + \sin\left((2r-\lambda)\frac{\pi}{4}\right) y_{\rho+\frac{N+1}{2}}(m-r) \right]$$

$$\text{für } 0 \leqslant \rho \leqslant \frac{N-1}{2}$$

$$\hat{x}_\rho(m) = \sum_{r=0}^{\lambda-1} \hat{h}_\rho(r) \left[ \cos\left((2r-\lambda)\frac{\pi}{4}\right) y_{\rho-\frac{N-1}{2}}(m-r) \right.$$

$$\left. - \sin\left((2r-\lambda)\frac{\pi}{4}\right) y_{\frac{3N-1}{2}}(m-r) \right]$$

$$\text{für } \frac{N+1}{2} \leqslant \rho \leqslant N-1$$

wobei $y_N(m) = 0$ ist, welchen Wert m auch haben mag,
für λ ungerade:

$$\hat{x}_\rho(m) = \sum_{r=0}^{\lambda-1} \hat{h}_\rho(r) \left[ \cos\left((2r-\lambda-1)\frac{\pi}{4}\right) y_\rho(m-r) \right.$$

$$\left. - \sin\left((2r-\lambda-1)\frac{\pi}{4}\right) y_{N-1-\rho}(m-r) \right]$$

$$\text{für } 0 \leqslant \rho \leqslant N-1.$$

**Claims**

1. A digital signal processing system comprising an analysing filter bank (12, 14) for dividing an incoming signal sampled at the rate $f_e$ and occupying a frequency band limited to $f_e/2$, into N contiguous subband signals having a bandwidth of $f_e/2N$ and being sampled at the rate $f_e/N$, and a

synthesising filter bank (15, 17) for recovering said incoming signal from said subband signals, said filter banks being formed by modulation of a prototype low-pass filter having a finite and symmetrical impulse response, having a beginning-of-attenuation-band frequency $f_a$ less than $f_e/2N$ and satisfying the condition $H^2(f) + H^2(f_e/2N - f) = 1$ in the band of frequencies f extending from 0 to $f_a$, where H(f) is the absolute value of the frequency response, modulating the prototype filter being effected by N sinusoidal modulation signals which, for forming the k-th subband (k extending from 0 to N−1) are characterized by the frequency $f_k = f_e/4N$ (2k+1), by the phase $\alpha_k$ for the analysing bank and by the phase $-\alpha_k$ for the synthesizing bank, the phase $\alpha_k$ being such that for the subband of the order of k = 0 the phase $\alpha_0 = \pi/4, 3\pi/4, 5\pi/4$ and such that for two contiguous subbands of the order of k and k−1 the difference $\alpha_k - \alpha_{k-1} = \pi/2$ or $-\pi/2$, characterized in that said modulation signals are furthermore delayed by a time delay $\tau = (N_c - 1)/(2f_e)$, where $N_c$ is the number of coefficients required for realizing the characteristics of the prototype filter.

2. A system as claimed in Claim 1, characterized in that the analysing bank is formed by: a polyphase network having N branches (12) over which, in each period NT, N samples of the signal entering the analysing bank are distributed, this polyphase network being arranged for calculating, at each period NT characterized by m and for each of its branches characterized by ρ (varying from 0 to N−1), a signal $P_\rho(m)$ produced from the coefficients of the prototype filter and from consecutive samples that have entered the branch, where

$\lambda$ is the integer value of $\dfrac{N + N_c - 1}{N}$ ,

a double-odd discrete cosine transform calculation arrangement (14) receiving the N signals $P_\rho(m)$ produced by the polyphase network and arranged for calculating the N subband signals $X_k(m)$ in accordance with an expression depending on the parities of $\lambda$ and N, viz:
for λ odd and for λ even and N even:

$$X_k(M7 = \sum_{\rho = 0}^{N - 1} C_N(k, \rho) \cdot P_\rho (m)$$

where

$$C_N(k, \rho) = 2 \cos \left[ \frac{(2k + 1)(2\rho + 1)\tilde{\pi}}{4N} \right]$$

for λ even and N odd:

$$X_k(m) = \sum_{\rho = 0}^{N - 1} C'_N(k, \rho) \cdot P_\rho (m)$$

where

$$C'_N(k, \rho) = 2 \cos \left[ \frac{2(k+1)\rho \, \tilde{\pi}}{2N} \right]$$

3. A system as claimed in Claim 2, characterized in that the polyphase network of the analysing bank is arranged for calculating each signal $P_\rho(m)$ in accordance with an expression depending on the parities of $\lambda$ and N, viz.
for even and N even:

$$\left\{ \begin{array}{l} P_\rho (m) = P^{(2)}_{\frac{N}{2} - 1 - \rho} (m) + P^{(2)}_{\frac{N}{2} + \rho} (m) \quad \text{for } 0 \leq \rho \leq \frac{N}{2} - 1 \\[2em] P_\rho (m) = P^{(1)}_{\rho - \frac{N}{2}} (m) - P^{(1)}_{\frac{3N}{2} - \rho - 1} (m) \quad \text{for } \frac{N}{2} \leq \rho \leq N - 1 \end{array} \right.$$

where

$$\begin{cases} P^{(1)}(m) = \sum_{r=0}^{\lambda-1} \hat{h}_{\rho}(r)\cos\left((2r-\lambda)\frac{\widetilde{\iota}}{4}\right) \cdot x_{\rho}(m-r) \\ \\ P^{(2)}(m) = \sum_{r=0}^{\lambda-1} \hat{h}_{\rho}(r)\sin\left((2r-\lambda)\frac{\widetilde{\iota}}{4}\right) \cdot x_{\rho}(m-r) \end{cases}$$

for $\lambda$ even and odd:

$$P_0(m) = P^{(2)}_{\frac{N-1}{2}}(m)$$

$$P_{\rho}(m) = -\left[ P^{(2)}_{\frac{N-1}{2}-\rho}(m) + P^{(2)}_{\frac{N-1}{2}+\rho}(m) \right] \quad \text{for } 1 \le \rho \le \frac{N-1}{3}$$

$$P_{\rho}(m) = P^{(1)}_{\rho-\frac{N+1}{2}}(m) - P^{(1)}_{\frac{3N-1}{2}-\rho}(m) \quad \text{for } \frac{N+1}{2} \le \rho \le N-1$$

for $\lambda$ odd:

$$P_{\rho}(m) = \sum_{r=0}^{\lambda-1} \hat{h}_{\rho}(r)\left[ \cos\left((2r-\lambda+1)\frac{\widetilde{\iota}}{4}\right) x_{\rho}(m-r) \right.$$

$$\left. + \sin\left((2r-\lambda+1)\frac{\widetilde{\iota}}{4}\right) x_{N-1-\rho}(m-\lambda+r+1) \right] \quad ,$$

$\hat{h}_{\rho}(r)$ representing $\lambda$ coefficients $h(n)$ of the prototype filter for $n = rN + \rho$, $x_{\rho}(m-r)$ representing $\lambda$ samples that have entered a branch of the polyphase network up to said period NT characterized by m.

4. A system as claimed in one of the Claims 1 to 3, characterized in that the synthesizing bank is formed by:
– a double-odd discrete cosine transform calculation arrangement (15) receiving N subband signals $X_k(m)$ and arranged for calculating N signals $y_{\rho}(m)$ in accordance with an expression depending on the parities of $\lambda$ and N, viz. for $\lambda$ odd and for $\lambda$ even and N even:

$$Y_{\rho}(m) = \sum_{k=0}^{N-1} C_N(k,\rho) \cdot X_k(m)$$

for $\lambda$ even and N odd:

$$Y_{\rho}(m) = \sum_{k=0}^{N-1} C'_N(k,\rho) \cdot X_k(m)$$

– an N-branch polyphase network receiving the signals $Y_{\rho}(m)$ and arranged for calculating, at each period NT characterized by m and for each branch characterized by $\rho$, a signal $\hat{x}_{\rho}(m)$ formed the $\lambda$ coefficients of the prototype filter and consecutive samples of $Y_{\rho}(m)$ that have entered the branch, the N samples of $\hat{x}_{\rho}(m)$ produced during each period NT being time-distributed for producing the output signal of the synthesizing bank.

5. A system as claimed in Claim 4, characterized in that the polyphase network of the synthesizing bank is arranged for calculating the signal $\hat{x}_{\rho}(m)$, in accordance with an expression depending on the parities of $\lambda$ and N, viz.

for $\lambda$ even and N odd:

$$\hat{x}_\rho(m) = \sum_{r=0}^{\lambda-1} \hat{h}_\rho(r) \left[ \cos\left((2r-\lambda)\frac{\tilde{\pi}}{4}\right) \cdot Y_{\frac{N}{2}-1-\rho}(m) \right.$$

$$\left. + \sin\left((2r-\lambda)\frac{\tilde{\pi}}{4}\right) \cdot Y_{\frac{N}{2}+\rho}(m-r) \right]$$

$$\hat{x}_{N-1-\rho}(m) = \sum_{r=0}^{\lambda-1} \hat{h}_\rho(r) \left[ \cos\left((2r-\lambda-2)\frac{\tilde{\pi}}{4}\right) \cdot Y_{\frac{N}{2}-1-\rho}(m-\lambda+r+1) \right.$$

$$\left. - \sin\left((2r-\lambda-2)\frac{\tilde{\pi}}{4}\right) \cdot Y_{\frac{N}{2}+\rho}(m-\lambda+r+1) \right]$$

for $0 \leq \rho \leq \frac{N}{2} - 1$

for $\lambda$ even and N even:

$$\hat{x}_\rho(m) = \sum_{r=0}^{\lambda-1} \hat{h}_\rho(r) \left[ \cos\left((2r-\lambda)\frac{\tilde{\pi}}{4}\right) y_{\frac{N-1}{2}-\rho}(m-r) \right.$$

$$\left. + \sin\left((2r-\lambda)\frac{\tilde{\pi}}{4}\right) y_{\rho+\frac{N+1}{2}}(m-r) \right]$$

for $0 \leq \rho \leq \frac{N-1}{2}$

$$\hat{x}_\rho(m) = \sum_{r=0}^{\lambda-1} \hat{h}_\rho(r) \left[ \cos\left((2r-\lambda)\frac{\tilde{\pi}}{4}\right) y_{\rho-\frac{N-1}{2}}(m-r) \right.$$

$$\left. - \sin\left((2r-\lambda)\frac{\tilde{\pi}}{4}\right) y_{\frac{3N-1}{2}}(m-r) \right]$$

for $\frac{N+1}{2} \leq \rho \leq N-1$

where $y_N(M) = 0$ whatever the value of
for $\lambda$ odd:

$$\hat{x}_{\rho}(m) = \sum_{r=0}^{\lambda-1} \hat{h}_{\rho}(r) \left[ \cos\left((2r - \lambda - 1)\frac{\tilde{\pi}}{4}\right) y_{\rho}(m-r) \right.$$

$$\left. - \sin\left((2r - \lambda - 1)\frac{\tilde{\pi}}{4}\right) y_{N-1-\rho}(m-r) \right]$$

for $0 \leq \rho \leq N - 1$.

FIG.1

FIG.2

FIG.3

4 <u>a</u>

4 <u>b</u>

FIG.4

FIG.5

EP 0 190 796 B1

FIG.6

EP 0 190 796 B1

FIG.7

FIG.8